# EUROPEAN PATENT APPLICATION

(11) **EP 1 630 602 A2**
(43) Date of publication of application: **01.03.2006**
(21) Application number: 05018257.5
(22) Date of filing: 23.08.2005
(51) Int. Cl.: G03F 7/00

(54) **Polymerizable composition, hydrophilic film formed by curing said composition and planographic printing plate precursor**

(30) Priority: 31.08.2004 JP 2004253171
(71) Applicant: FUJI PHOTO FILM CO., LTD., Minami-Ashigara-shi, Kanagawa (JP)
(72) Inventor: Shimada, Kazuto Fuji Photo Film Co., Ltd., Haibara-gun Shizuoka-ken (JP); Hoshi, Satoshi Fuji Photo Film Co., Ltd., Haibara-gun Shizuoka-ken (JP)
(74) Representative: HOFFMANN EITLE

(57) **Abstract**

A polymerizable composition including a hydrophilic polymer (A) having a radical polymerizable group on the terminal, a radical polymerizable compound (B), and a polymerization initiator (C); a hydrophilic film formed by curing a film by application of light or heat, which film includes the polymerizable composition; and a planographic printing plate precursor including a support and the hydrophilic film formed on or above the support.

## Description

### BACKGROUND OF THE INVENTION

### Field of the Invention

The present invention relates to a polymerizable composition capable of forming a hydrophilic film, a hydrophilic film prepared by using the polymerizable composition, and a planographic printing plate precursor having the hydrophilic film as a recording layer.

### Description of the Related Art

Planographic printing is a printing method which uses a plate material including a lipophilic area for receiving an ink and an ink-repellence area (hydrophilic area) for receiving a fountain solution instead of ink. At present, photosensitive planographic printing plate precursors (PS plate) are widely used. In particular, PS plates having a photosensitive layer formed on a support such as an aluminum plate and the like are widely used in practice. In such PS plates, the photosensitive layer of the non-image area is removed by image exposure and development, and the hydrophilicity of the substrate surface and the lipophilicity of the photosensitive layer on the image area for printing are used to carry out printing. In such plate materials, high hydrophilicity is required to prevent staining of the non-image area.

In recent years, various research has been conducted with respect to printing plates for computer-to-plate systems, which have undergone remarkable development. Among such research, a planographic printing plate precursor capable of being mounted on a printing machine for printing without development processing after exposure has been studied and various methods have been proposed, for the purposes of further rationalizing the process and solving the waste fluid disposal problem. One method for eliminating the processing step is a method called on-machine development wherein an exposed printing plate precursor is mounted on a cylinder of a printing machine and a fountain solution and a printing ink are supplied to the printing plate precursor while rotating the cylinder, thereby removing the non-image area of the printing plate precursor. That is, after exposing a printing plate precursor, the printing plate precursor is mounted on a printing machine and an ordinary printing step is carried out to complete the process.

A planographic printing plate precursor suitable for on-machine development is required to have a photosensitive layer soluble in a fountain solution and an ink solvent and also light-room handling properties suitable for development on a printing machine placed in a light room. As a printing plate that does not require development processing, a non-process requiring printing plate which has a crosslinked hydrophilic layer formed on the substrate, and contains a microencapsulated heat-melting substance therebetween, has been disclosed (see, for example, International Publication (WO) No. 94/23954). In this printing plate, the microcapsules is ruptured by the heat generated from the laser exposure area, causing the lipophilic substance in the capsule to melt out, whereby the hydrophilic layer surface is hydrophobized. The printing plate precursor does not require development processing, but due to insufficient hydrophilicity or durability of the hydrophilic layer formed on the substrate, there has been a problem that stains are slowly generated on the non-image area as printing progresses.

For the purpose of improving hydrophilicity and durability, a hydrophilic layer formed by curing acrylamide-hydroxyethylacrylate copolymer using a methylol melamine crosslinking agent (see, for example, Japanese Patent Application Laid-Open (JP-A) No. 2002-370467), a hydrophilic layer using gelatin or polyvinyl alcohol (see, for example, JP-A No. 11-95417), a hydrophilic layer using a quaternary ammonium salt polymer (see, for example, Japanese National Phase Publication No. 2003-527978), and the like, have been proposed. Improvements have been attained to some degree by improving the hydrophilicity of the polymer used or the crosslinking structure, but the level of hydrophilicity required for practical use as a printing plate remains to be fully achieved. Thus, at present, a product which is satisfactory in the terms of a lack of residual stains or ink removability has not been yet obtained.

### SUMMARY OF THE INVENTION

The present invention has been made in view of the above circumstance and provides a polymerizable composition capable of forming a highly hydrophilic and highly strong film, and a cured hydrophilic film formed by the polymerizable composition. The invention also provides a planographic printing plate precursor which is prepared by using the hydrophilic film and has excellent hydrophilicity and durability in the non-image area.

The inventors have conducted extensive research and as a result, have discovered the use of a specific hydrophilic polymer having a radical polymerizable group on a terminal thereof, to complete the invention.

That is, a first aspect of the invention provides a polymerizable composition comprising a hydrophilic polymer (A) having a radical polymerizable group on a terminal, a radical polymerizable compound (B), and a polymerization initiator (C).

A second aspect of the invention provides a hydrophilic film formed by curing a film by application of light or heat, wherein the film comprises a polymerization composition comprising a hydrophilic polymer (A) having a radical polymerizable group on a terminal, a radical polymerizable compound (B), and a polymerization initiator (C).

A third aspect of the invention provides a planographic printing plate precursor comprising a support and the hydrophilic film of the second aspect formed on or above the support.

Such a hydrophilic film preferably contains at least one kind selected from a compound (D-1) whose hydrophilicity is converted to hydrophobicity upon application of heat or particles (D-2) whose hydrophilicity is converted to hydrophobicity upon application of heat. Further, it preferably contains an infrared absorbent (E) in view of sensitivity.

Although the mechanism by which the hydrophilic film prepared by using the polymerizable composition of the invention exhibits high hydrophilicity and excellent strength is not clear, starting with a terminal polymerizable group of a polymer (A) having a radical polymerizable group on the terminal, a three-dimensional crosslinked film having high crosslinking density and high strength can be obtained by curing a hydrophilic polymer (A) via radical polymerization using initiating species such as a radical generated from a polymerization initiator (C) and a radical polymerizable compound (B). Further, at the time of crosslinking, the hydrophilic polymer is chemically fixed strongly at the terminal thereof throughout the crosslinked film, and since the polymer chain having a hydrophilic unit is highly dynamic, water permeation, discharging water and the like can be carried out efficiently. It is believed that a crosslinked film having high hydrophilicity and high strength can be obtained for these reasons.

By using such a polymerizable group and polymerizable compound, formation of a film similar to formation of a surface graft polymer on the substrate becomes possible, and thus by using a multifunctional polymerizable compound herein, a film having high crosslinking density and high strength can be obtained. Further, the hydrophilic cured film of the invention is advantageous in terms of easy formation of the desired thickness of the film by differentiating the coating amount of the polymerizable composition as well as easy introduction of an image forming factor into the crosslinked film. In addition, by using such a polymerizable compound and a polymer having the polymerizable group, freedom to select a support is increased, and thus a hydrophilic film having excellent adhesiveness may be formed not only on a metal support, but also on the surface of an organic resin support such as polyethylene telephthalate.

### DETAILED DESCRIPTION OF THE INVENTION

The hydrophilic film using the polymerizable composition of the invention is characterized in that it comprises a highly dynamic hydrophilic unit the terminal of which is strongly bonded to a film having a crosslinking structure. A polymerizable compound useful for forming such a hydrophilic film includes: a hydrophilic polymer (A) having a radical polymerizable group on the terminal, a radical polymerizable compound (B), and a polymerization initiator (C). Below, components contained in the polymerizable composition of the invention are described.

### <Hydrophilic polymer (A) having a radical polymerization group on the terminal>

As for the hydrophilic polymer (A) having a radical polymerization group on a terminal thereof (hereinafter, referred to as "a specific hydrophilic polymer (A)") which can be used in the invention, a known macro monomer (also referred to as "a macromer") having a double bond on the terminal can be used. A method for preparing the macromer, for example, various preparation methods are exemplified in the "Chemistry and Industry of Macromonomer" (edited by Yamashita Yuuya) published by IPC Publications (September 20, 1989), Chapter 2 "Synthesis of Macro Monomers". Further, the macro monomers are disclosed in the "Experimental Chemistry of Novel Polymers 2: Polymer Synthesis and Reaction" (edited by The Society of Polymer Chemistry) and the like. Among the disclosed macromonomers, ones having a hydrophilic group in the molecule as well as having a double bond on the terminal may be used as a specific hydrophilic polymer (A) of the invention.

Among the hydrophilic macromonomers used in the invention, a macromonomer derived from a monomer containing carboxyl group such as acrylic acid and methacrylic acid, a sulfonic acid-based macromonomer derived from 2-acrylamide-2-methylpropane sulfonic acid, vinyl styrene sulfonic acid or their salt monomer, an amide-based macromonomer derived from (meth)acrylamide, N-vinyl acetamide, N-vinyl formamide, N-vinyl carboxylic acid amide monomer or the like, a macromonomer derived from a monomer containing a hydroxyl group such as hydroxyethyl methacrylate, hydroxyethyl acrylate or glycerol monomethacrylate, and a macromonomer derived from a monomer containing alkoxy or ethylene oxide such as methoxyethyl acrylate, methoxypolyethyleneglycol acrylate and polyethyleneglycol acrylate are particularly useful. Further, monomers having an ether group such as a polyethylene glycol chain or a polypropylene glycol chain may also be favorably used as the macromonomer of the invention. In addition, a macromonomer derived from a monomer having a double bond group and a cationic group such as ammonium, sulfonium, iodium and the like can be used.

Among the macromonomers, useful macromonomers are those having a molecular weight in a range of 250 to 100,000, and preferably 400 to 30,000. Further, when forming a hydrophilic film, a hydrophilic monomer may further be added to the hydrophilic polymer having a polymerizable group. Addition of a hydrophilic monomer can increase the rate of polymerization. The amount of the added hydrophilic monomer is preferably 0 to 60% by mass. When the amount is 60% by mass or less, uniform coating can easily be attained due to excellent coatability.

Examples of preferable functional groups contained in the hydrophilic macromonomer include a hydroxyl group, an alkoxy group, a carboxyl group or a salt thereof, a sulfonic acid group or a salt thereof, a phosphonic acid group or a salt thereof, a sulfinic acid group or a salt thereof, an amide group, a sulfuric acid group or a salt thereof, an ammonium group, an ethyleneoxy group, a propyleneoxy group, a urethane group, a morpholino group, an iodium group, a sulfonium group, a phosphonium group, or the like. From the viewpoint of hydrophilicity, an alkyl sulfonic acid group or a salt thereof, or an amide group is preferable.

The hydrophilic polymer of the invention having a radical polymerizable group on the terminal can contain a hydrophobic (meth)acrylate derivative compound, a (meth)acrylamide derivative compound or a styryl-based compound within a range where hydrophilicity is not lowered greatly in terms of function.

Examples of specific hydrophilic polymer (A) which can be used in the invention are shown below, but the invention is not limited thereto.

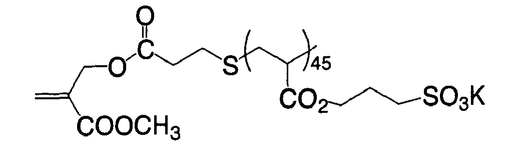

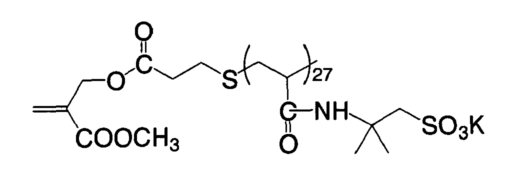

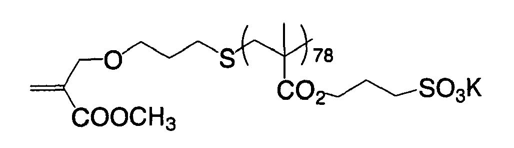

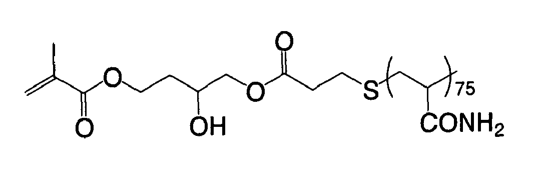

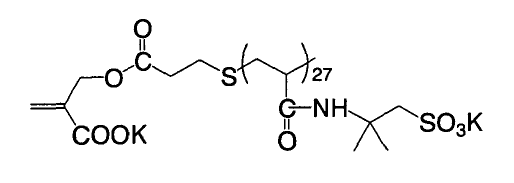

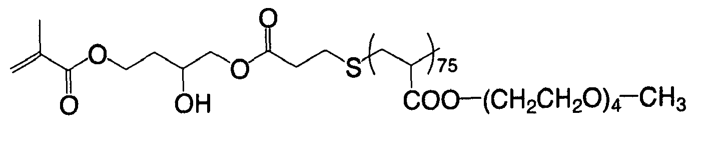

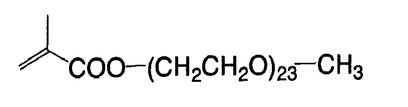

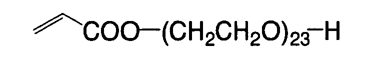

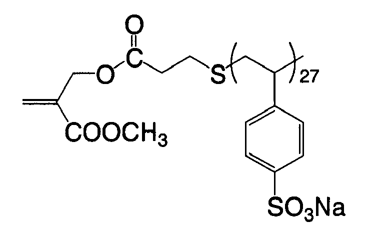

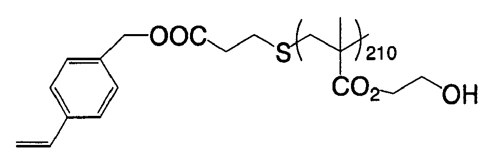

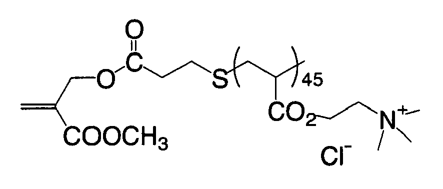

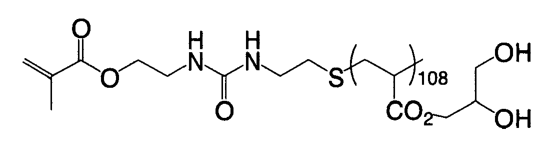

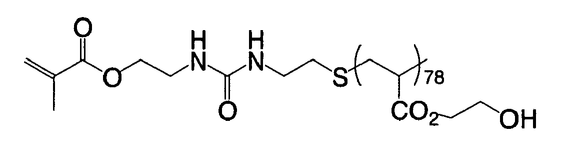

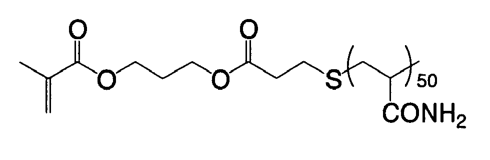

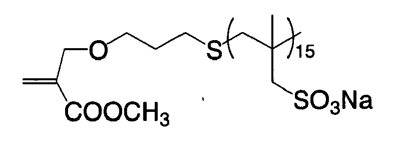

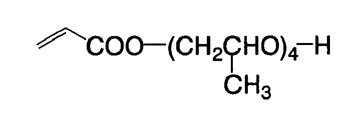

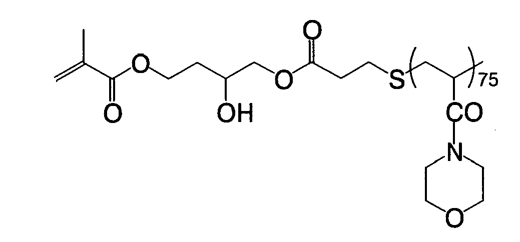

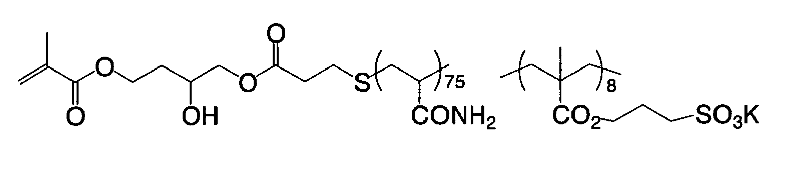

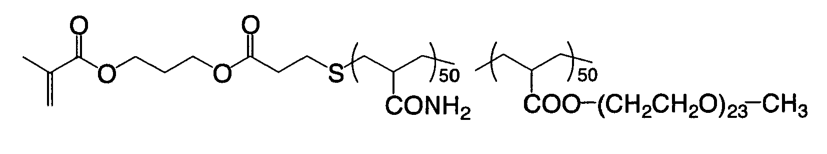

The hydrophilic polymer (A) having a radical polymerizable group on the terminal according to the invention, from the viewpoint of curability and hydrophilicity, is preferably contained in a range of from 5 to 95% by mass, more preferably from 15 to 90% by mass, and most preferably from 25 to 85% by mass, based on the nonvolatile components of the polymerizable composition of the invention. Only a single compound may be used or two or more compounds may be used.

### <Radical polymerizable compound (B) >

The radical polymerizable compound (B) which can be used in the invention is an addition-polymerizable compound having at least one ethylenically unsaturated double bond, and is selected from compounds each having at least one (preferably two or more) terminal ethylenic unsaturated bond. The radical polymerizable compound is useful for forming a crosslinking structure. Such compounds are known widely in the related industrial field, and in the invention, the polymerizable compound is selected from these compounds without any particular limitation. The radical polymerizable compound may be in the chemical form of a monomer, a prepolymer (a dimer, a trimer, an oligomer, or the like), a mixture thereof, or a copolymer thereof.

Examples of the monomer and copolymer include unsaturated carboxylic acids (e.g., acrylic acid, methacrylic acid, itaconic acid, crotonic acid, isocrotonic acid, and maleic acid), esters thereof, and amides thereof. The polymerizable monomer is preferably: an ester between an unsaturated carboxylic acid and an aliphatic polyvalent alcohol; an amide between an unsaturated carboxylic acid and an aliphatic polyvalent amine; an addition-reaction product of an unsaturated carboxylic ester or amide having a nucleophilic substituent such as a hydroxyl group, an amino group, or a mercapto group, with a monofunctional or multifunctional isocyanate or an epoxy compound; a dehydration condensation reaction product of an unsaturated carboxylic ester or amide having a nucleophilic substituent such as a hydroxyl group, an amino group, or a mercapto group, with a monofunctional or multifunctional carboxylic acid; an addition-reaction product of an unsaturated carboxylic ester or amide having an electrophilic substituent such as an isocyanate group or an epoxy group, with a monofunctional or multifunctional alcohol, amine or thiol; or a substitution-reaction product of an unsaturated carboxylic ester or amide having an dissociative substituent such as a halogen group or a tosyloxy group, with a monofunctional or multifunctional alcohol, amines or thiol. In the above examples, the unsaturated carboxylic acid may be replaced by an unsaturated phosphonic acid, styrene, a vinyl ether, or the like.

The ester (monomer) between an aliphatic polyvalent alcohol and an unsaturated carboxylic acid may be an acrylic ester. Examples such an acrylic ester include ethylene glycol diacrylate, triethylene glycol diacrylate, 1,3-butane diol diacrylate, tetramethylene glycol diacrylate, propylene glycol diacrylate, neopentyl glycol diacrylate, trimethylol propane triacrylate, trimethylol propane tri(acryloyloxypropyl)ether, trimethylol ethane triacrylate, hexane diol diacrylate, 1,4-cyclohexane diol diacrylate, tetraethylene glycol diacrylate, pentaerythritol diacrylate, pentaerythritol triacrylate, pentaerythritol tetracrylate, dipentaerythritol diacrylate, dipentaerythritol hexacrylate, sorbitol triacrylate, sorbitol tetracrylate, sorbitol pentacrylate, sorbitol hexacrylate, tri(acryloyloxyethyl) isocyanurate, polyester acrylate oligomers, and isocyanuric acid EO-modified triacrylate.

The ester (monomer) between an aliphatic polyvalent alcohol and an unsaturated carboxylic acid may be a methacrylic ester. Examples such a methacrylic ester include tetramethylene glycol dimethacrylate, triethylene glycol dimethacrylate, neopentyl glycol dimethacrylate, trimethylol propane trimethacrylate, trimethylol ethane trimethacrylate, ethylene glycol dimethacrylate, 1,3-butane diol dimethacrylate, hexane diol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis(p-(3-methacryloxy-2-hydroxypropoxy)phenyl)dimethyl methane, and bis(p-(methacryloxyethoxy)phenyl)dimethyl methane.

The ester (monomer) between an aliphatic polyvalent alcohol and an unsaturated carboxylic acid may be an itaconic ester. Examples such an itaconic ester include ethylene glycol diitaconate, propylene glycol diitaconate, 1,3-butane diol diitaconate, 1,4-butane diol diitaconate, tetramethylene glycol diitaconate, pentaerythritol diitaconate, and sorbitol tetraitaconate. The ester (monomer) between an aliphatic polyvalent alcohol and an unsaturated carboxylic acid may be a crotonic ester. Examples such a crotonic ester include ethylene glycol dicrotonate, tetramethylene glycol dicrotonate, pentaerythritol dicrotonate, and sorbitol tetradicrotonate. The ester (monomer) between an aliphatic polyvalent alcohol and an unsaturated carboxylic acid may be an isocrotonic ester. Examples such an isocrotonic ester include ethylene glycol diisocrotonate, pentaerythritol diisocrotonate, and sorbitol tetraisocrotonate. The ester (monomer) between an aliphatic polyvalent alcohol and an unsaturated carboxylic acid may be a maleic ester. Examples of such a maleic ester include ethylene glycol dimaleate, triethylene glycol dimaleate, pentaerythritol dimaleate, and sorbitol tetramaleate.

The radical polymerizable compound may be an ester other than the esters described above. Examples of such an ester include aliphatic alcohol-based esters described in JP-B No. 51-47334 and JP-A No. 57-196231, esters each having an aromatic skeleton described in JP-A Nos. 59-5240, 59-5241 and 2-226149, and esters each having an amino group described in JP-A No. 1-165613. It is also possible to use a mixture of ester monomers selected from the ester monomers described above.

Examples of the amide (monomer) between an aliphatic polyvalent amine and an unsaturated carboxylic acid include methylene bis-acrylamide, methylene bis-methacrylamide, 1,6-hexamethylene bis-acrylamide, 1,6-hexamethylene bis-methacrylamide, diethylene triamine trisacrylamide, xylylene bisacrylamide, and xylylene bismethacrylamide. Preferable examples of other amide type monomers include the amid type monomers each having a cyclohexylene structure described in JP-B No. 54-21726.

The radical polymerizable compound may be an urethane addition-polymerizable compound produced by addition reaction between an isocyanate and a hydroxyl group. The urethane addition-polymerizable compound may be a vinyl urethane compound having two or more polymerizable vinyl groups disclosed in JP-B No. 48-41708. The vinyl urethane compound can be prepared by allowing a vinyl monomer having a hydroxyl group represented by the following formula (II) and a polyisocyanate having two or more isocyanate groups to undergo an addition reaction.

CH₂=C(R₄)COOCH₂CH(R₅)OH (II)

wherein R₄ and R₅ each independently represent H or CH₃.

The radical polymerizable compound may be selected from the urethane acrylates described in JP-A No. 51-37193, JP-B Nos. 2-32293 and 2-16765 and the urethane compounds having ethylene oxide type skeletons described in JP-B Nos. 58-49860, 56-17654, 62-39417 and 62-39418. Addition-polymerizable compounds each containing an amino structure or sulfide structure described in JP-A Nos. 63-277653, 63-260909 and 1-105238 can be used to prepare photopolymerizable compositions extremely excellent in photosupersensitization speed.

Examples of the radical polymerizable compound further include: multifunctional acrylates and methacrylates such as polyester acrylates disclosed in JP-A No. 48-64183, JP-B Nos. 49-43191 and 52-30490 and epoxy acrylates obtained by allowing epoxy resins to react with (meth)acrylic acid; specific unsaturated compounds disclosed in JP-B Nos. 46-43946, 1-40337 and 1-40336; vinyl phosphonic acid compounds disclosed in JP-A No. 2-25493; a structure containing a perfluoroalkyl group disclosed in JP-A No. 61-22048; and photosetting monomers and oligomers disclosed in the Journal of Japanese Adhesive Society, vol. 20, No. 7, pp. 300-308 (1984).

Details (such as the structure, amount, and whether used alone or in combination with another addition-polymerizable compounds) of the method for using the radical polymerizable compound (B) may be arbitrary determined in accordance with the design of the performance of the resultant planographic printing plate precursor. For example, the radical polymerizable compound can be selected from the following viewpoints.

In respect of the sensitivity, the radical polymerizable compound preferably has a structure containing many unsaturated groups in one molecule; in many cases, the addition-polymerizable compound preferably has bi-or higher-functionality. To increase the strength of the image area (cured layer), the addition-polymerizable compound preferably has tri- or higher-functionality. It is also effective to control both the sensitivity and the strength by using a combination of addition-polymerizable compounds (e.g. acrylates, methacrylates, styrene compounds, and vinyl ether compounds) having different functionalities and different polymerizable groups.

In respect of the hydrophilicity of the cured layer, it is preferable that the radical polymerizable compound includes a hydrophilic group such as an ethylene oxide, an alcohol, an acid group or a salt thereof.

The selection and manner of use of the radical polymerizable compound is an important factor for compatibility with other components (e.g. a binder polymer, an initiator, and a colorant) in the polymerizable composition and dispersibility. The compatibility may be improved by using e.g. a compound with low purity or a combination of two or more radical polymerizable compounds. A specific structure can be selected for the purpose of improving the adhesion of the image recording layer to a support, an overcoat layer described later, etc.

The radical polymerizable compound (B) is used preferably in the range of 5 to 80% by mass, more preferably 10 to 60 % by mass, based on the mass of the nonvolatile components in the polymerizable composition of the invention. Only a single addition-polymerizable compound may be used, or two or more addition-polymerizable compounds may be used. When the radical polymerizable compound is used, the structure, amount, addition manner of the addition-polymerizable compound may be selected arbitrary, considering the degree of polymerization inhibition caused by oxygen, the resolution, the fogging property, the change in reflectance, and the surface adhesiveness. An undercoat layer and/or an overcoat layer may also be provided.

### <Polymerization initiator (C) >

The polymerization initiator (radical generator) used in the invention refers to a compound which generates radicals upon application of light energy and/or heat energy, thus initiates and promotes the polymerization of the radical polymerizable compound (B). The polymerization initiator (radical generator) used in the invention may be a known heat polymerization initiator, a compound having a bond with a low bond dissociation energy, or a photopolymerization initiator. Only a single radical generator may be used, or two or more radical generators may be used simultaneously.

Examples of the radical generator include an organic halogenated compound, a carbonyl compound, an organic peroxide compound, an azo polymerization initiator, an azide compound, a metallocene compound, a hexaaryl biimidazole compound, an organic boric acid compound, a disulfonic acid compound, an oxime ester compound, and an onium salt compound (e.g. sulfonium, iodonium, diazonium, pyridinium).

Examples of the organic halogenated compound include compounds described in Wakabayashi et al.: *Bull. Chem. Soc. Japan,* 42, 2924 (1969), US Patent No. 3,905,815, JP-B No. 46-4605, JP-A Nos. 48-36281, 55-32070,60-239736, 61-169835, 61-169837, 62-58241, 62-212401, 63-70243 and 63-298339, and M. P. Hutt: Journal of Heterocyclic Chemistry, 1 (No. 3), (1970). The organic halogenated compound may be an oxazole compound substituted by a trihalomethyl group or an S-triazine compound.

The azo compound may be, for example, selected from the azo compounds described in No. JP-A 8-108621.

The metallocene compound may be selected from various titanocene compounds described in JP-A Nos. 59-152396, 61-151197, 63-41484, 2-249, 2-4705 and 5-83588.

The hexaaryl biimidazole compound may be selected from, for example, various compounds described in JP-B No. 6-29285, and US Patent Nos. 3,479,185, 4,311,783, and 4,622,286. Examples of the organic borate compound include: organic borate compounds described in JP-A Nos. 62-143044, 62-150242, 9-188685, 9-188686, 9-188710, 2000-131837 and 2002-107916, Japanese Patent No. 2764769, JP-A No. 2002-116539, and Kunz, Martin: Rad Tech '98, Proceeding April 19-22, 1998, Chicago; organic boron sulfonium complexes and organic boron oxosulfonium complexes described in JP-A Nos. 6-157623, 6-175564 and 6-175561; organic boron iodonium complexes described in JP-A Nos. 6-175554 and 6-175553; organic boron phosphonium complexes described in JP-A No. 9-188710; and organic boron transition metal coordination complexes described in JP-A Nos. 6-348011, 7-128785, 7-140589, 7-306527 and 7-292014.

The disulfone compound may be selected from the compounds described in JP-A Nos. 61-166544 and 2002-328465.

The oxime ester compound may be selected from the compounds described in J. C. S. Perkin II (1979) 1653-1660), J. C. S. Perkin II (1979) 156-162, Journal of Photopolymer Science and Technology (1995) 202-232 and JP-A Nos. 2000-66385 and 2000-80068. Examples of the onium salt compound include: diazonium salts described in S. I. Schlesinger, Photogr. Sci. Eng., 18, 387 (1974) and T. S. Bal et al., Polymer, 21, 423 (1980); ammonium salts described in US Patent No. 4,069,055 and JP-A No. 4-365049, phosphonium salts described in US Patent Nos. 4,069,055 and 4,069,056; iodonium salts described in European Patent No. 104,143, US Patent Nos. 339,049 and 410,201, JP-A Nos. 2-150848 and 2-296514; sulfonium salts described in European Patent Nos. 370,693, 390,214, 233,567, 297,443 and 297,442, US Patent Nos. 4,933,377, 161,811, 410,201, 339,049, 4,760,013, 4,734,444 and 2,833,827, and German Patent Nos. 2,904,626, 3,604,580 and 3,604,581; selenonium salts described in J. V. Crivello et al., Macromolecules, 10(6), 1307 (1977) and J. V. Crivello et al., J. Polymer Sci., Polymer Chem. Ed., 17, 1047 (1979); and onium salts such as arsonium salts described in C. S. Wen et al., Teh, Proc. Conf. Rad. Curing ASIA, p. 478, Tokyo, Oct (1988).

As for other preferable polymerization initiators, an α-hydroxyacetophenone-type initiator or a derivative thereof, benzophenone or a derivative thereof, or the like may be preferably used.

The polymerization initiator (C) can be used without limitation as long as it initiates polymerization upon application of light or heat as described above. However, from the viewpoint of staining of a hydrophilic layer, it is preferable that the polymerization initiator contains a hydrophilic group. Preferred examples of the hydrophilic group include a hydroxyl group, a phenol group, carboxylic acid, sulfonic acid, phosphoric acid, sulfonamide, ethylene oxide or salts thereof, or an amine salt.

The polymerizable composition of the invention comprises the essential components of (A) to (C) above and may comprise other components. Such a polymerizable compound is coated with an appropriate solvent, and is given energy by application of light, heat or both, whereby the coated film is cured to obtain a hydrophilic film having a hydrophilic unit which is highly dynamic and having a crosslinked structure.

Such a hydrophilic film formed on or above a support can be used as a recording layer thereby obtaining a planographic printing plate precursor of the invention. When using the hydrophilic film as a recording layer in the planographic printing plate precursor of the invention, for image forming, the desired portion of the hydrophilic film is hydrophobized in a imagewise manner.

In order to perform such image forming, that is, in order to form the hydrophobic area, a compound which hydrophobizes the area upon application of energy may be added to the hydrophilic film. Hereinafter, a compound used for forming a hydrophobized area is described.

### <Compound (D) which hydrophobizes a hydrophilic layer by heat or light>

When using the hydrophilic film of the invention as a recording layer of the planographic printing plate precursor, it is preferable that a compound having an image forming function is added to the hydrophilic film. That is, a compound capable of forming a hydrophobic area upon application of heat or radiation is preferably added. Examples thereof include a compound (D-1) or polymer particles (D-2) wherein the physical property of hydrophilicity is converted to hydrophobicity upon application of heat or radiation.

As for the compound (D-1) whose hydrophilicity is converted to hydrophobicity, examples thereof include a polymer having a functional group whose hydrophilicity is converted to hydrophobicity through decarboxylation upon application of heat, as described in JP-A No. 2000-122272, and specifically, preferable examples include the polymer compounds described below. Particularly preferable physical properties are such that the contact angle of an aerial water droplet with the surface of a film prepared by applying the polymer itself is 20° or less before application of heat and changed to 65° or more after application of heat. However the invention is not limited to such.

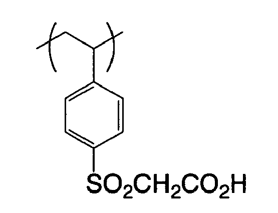

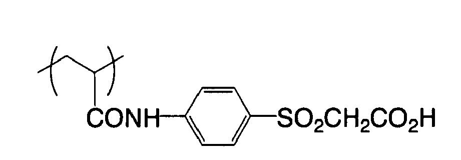

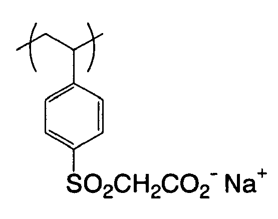

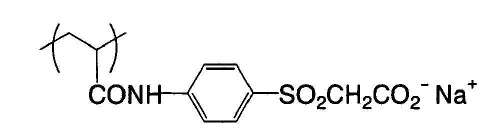

The polymer particles (D-2) of the invention are those which can hydrophobize the hydrophilic image recording layer upon application of heat. Such particles are preferably at least one kind selected from thermoplastic polymer particles, thermoreactive polymer particles, or microcapsules encapsulating a compound having a thermoreactive group.

As for the thermoplastic polymer particles (D-2) added to the hydrophilic film of the invention, preferable examples thereof include the thermoplastic polymer particles as described in Research Disclosure No. 33303 (Jan. 1992), JP-A Nos. 9-123387, 9-131850, 9-171249 and 9-171250, EP No. 931647 and the like. Specific examples of the polymer constituting the polymer particle include homopolymers and copolymers of monomers such as ethylene, styrene, vinyl chloride, methyl acrylate, ethyl acrylate, methyl methacrylate, ethyl methacrylate, vinylidene chloride, acrylonitrile, vinyl carbazole or the like, or a mixture thereof. Among them, more preferred are polystyrene and polymethyl methacrylate.

The average particle size of the thermoplastic polymer particles used in the invention is preferably from 0.01 to 2.0 µm. Examples of the method for synthesis of such the thermoplastic polymer particles include, in addition to a emulsion polymerization method and a suspension polymerization method, a method of dissolving those compounds in a non-aqueous organic solvent, mixing and emulsifying the resulting solution with an aqueous solution containing a dispersant, and solidifying the mixture into a particulate form while evaporating the organic solvent by applying more heat (dissolution dispersion method).

Examples of the thermoreactive polymer particles (D-2) which are used in the invention include thermosetting polymer particles (D2-1) and polymer particles (D-2-2) having a thermoreactive group.

Examples of the thermosetting polymer (D-2-1) include a resin having a phenolic skeleton, a urea-based resin (e.g., a resin obtained by resinification of urea or a derivative thereof such as methoxymethylated urea by aldehyde such as formaldehyde and the like), a melamine-based resin (e.g., a resin obtained by resinification of melamine or a derivative thereof by aldehyde such as formaldehyde and the like), an alkyd resin, an unsaturated polyester resin, a polyurethane resin, an epoxy resin and the like. Among them, particularly preferred are the resins having a phenolic skeleton, the melamine resin, the urea resin and the epoxy resin.

As for the resin having a phenolic skeleton, preferable examples thereof include a phenolic resin obtained by resinifying phenol, cresol or the like by aldehyde such as formaldehyde and the like, a hydroxystyrene resin, and a polymer or copolymer of methacrylamide, acrylamide, methacrylate or acrylate having a phenolic skeleton, such as N-(p-hydroxyphenyl)methacrylamide, p-hydroxyphenyl methacrylate and the like.

The average particle size of the thermosetting polymer particle used in the invention is preferably from 0.01 to 2.0 µm. Such thermosetting polymer particles can be obtained by a dissolution dispersion method, but it is also possible to obtain particles during the synthesis of the thermosetting polymer. However, the method is not limited to this.

As for the thermoreactive group of the polymer particles (D-2-2) having a thermoreactive group as used in the invention, any functional group may be used without limitation of the reaction the functional group may undergo as long as a chemical bond is formed, but preferable examples thereof include an ethylenically unsaturated group which may undergo a radical polymerization reaction (e.g., an acryloyl group, a methacryloyl group, a vinyl group, an allyl group, etc.), a cationic polymerizable group (e.g., a vinyl group, a vinyloxy group, etc.), an isocyanate group which may undergo an addition reaction or its block form, an epoxy group, a vinyloxy group and a functional group having an active hydrogen atom which is the counterpart in the reaction involving the above functional groups (e.g., an amino group, a hydroxyl group, a carboxyl group, etc.), a carboxyl group which may undergo a condensation reaction and its counterpart hydroxyl group or amino group, an acid anhydride which may undergo a ring-opening addition reaction and its counterpart amino group or hydroxyl group, and the like.

Introduction of such functional group into the polymer particle may be carried out during polymerization or after polymerization via a polymeric reaction.

In the case of introducing the functional group during polymerization, it is preferable to subject a monomer having the foregoing functional group to emulsion polymerization or suspension polymerization. Specific examples of the monomer having the foregoing functional group include aryl methacrylate, aryl acrylate, vinyl methacrylate, vinyl acrylate, 2-(vinyloxy)ethyl methacrylate, p-vinyloxystyrene, p-{2-(vinyloxy)ethyl} styrene, glycidyl methacrylate, glycidyl acrylate, 2-isocyanatoethyl methacrylate or its block isocyanate with an alcohol or the like, 2-isocyanatoethyl acrylate or its block isocyanate with an alcohol or the like, 2-aminoethyl methacrylate, 2-aminoethyl acrylate, 2-hydroxyethyl methacrylate, 2-hydroxyethyl acrylate, acrylic acid, methacrylic acid, maleic anhydride, bifunctional acrylate, bifunctional methacrylate and the like, without being limited to these.

In the invention, the copolymers of such the monomer and a monomer with no thermoreactive group, capable of copolymerizing with such monomer can be used. Examples of a copolymerizable monomer with no thermoreactive group include styrene, alkyl acrylate, alkyl methacrylate, acrylonitrile, vinyl acetate and the like, without being limited to these.

As for the polymeric reaction for introducing a thermoreactive group after the polymerization, example thereof include a polymeric reaction disclosed in WO 96/34316.

Among the polymer particles having a thermoreactive group, those may coalesce with each other upon application of heat are preferred, and those having a hydrophilic surface and dispersing in water are particularly preferred. It is preferable that the contact angle (aerial water droplet) of a film prepared by applying only the polymer particles and drying them at a temperature lower then the coagulation temperature, is smaller than the contact angle (aerial water droplet) of a film prepared by drying at a temperature higher than the coagulation temperature. In order to make the surface of the particles hydrophilic, a hydrophilic polymer such as polyvinyl alcohol, polyethylene glycol or the like, or an oligomer or a hydrophilic low-molecular-weight compound may be adsorbed on the surface of the particles. However, the surface-hydrophilization method is not limited thereto.

The coagulation temperature of the polymer particles having a thermoreactive group is preferably 70°C or higher, and in view of the stability over time, more preferably 100°C or higher. The average particle size of the polymer particles is preferably from 0.01 to 2.0 µm, more preferably from 0.05 to 2.0 µm, and most preferably from 0.1 to 1.0 µm. Within these ranges, good resolution and stability over time can be obtained.

Modified examples of the polymer particle (D-2), which is a material for forming hydrophobized area, include a microcapsule. The microcapsule used as a material for forming hydrophobized area encapsulates a hydrophobic compound. Such the hydrophobic compound is preferably a compound having a thermoreactive group. Preferable examples of the thermoreactive group include those exemplified as the thermoreactive groups of the above-described polymer particle having a thermoreactive group. The compound having a thermoreactive group are described in further detail below.

As for the compound having a radical polymerizable unsaturated group, examples thereof include compounds having at least one, preferably two or more ethylenically unsaturated bonds, for example an acryloyl group, a methacryloyl group, a vinyl group, an aryl group, a styryl group or the like. These compounds are well known in the art as a monomer or a crosslinking agent for a polymerizable composition, and they can be used in the invention without particular limitation. Chemical form thereof may be a monomer, a prepolymer, namely, a dimer, a trimer or an oligomer, a polymer or a copolymer, or a mixture thereof.

Specific examples thereof include the compounds having a polymerizable unsaturated group as described in JP-A No. 2001-277740. Examples of the representative compounds include trimethylolpropane di(meth)acrylate, trimethylolpropane tri(meth)acrylate, pentaerythritol di(meth)acrylate, pentaerythritol tri(meth)acrylate, pentaerythritol tetra(meth)acrylate, dipentaerythritol di(meth)acrylate, dipentaerythritol penta(meth)acrylate, dipentaerythritol hexa(meth)acrylate, and an adduct of trimethylolpropane diacrylate and xylenediisocyanate, and the like, without being limited to these.

A polymer or copolymer having an ethylenic polymerizable unsaturated group may be an arylmethacrylate copolymer. Examples thereof include an aryl methacrylate/methacrylate copolymer, an aryl methacrylate/ethyl methacrylate copolymer, an aryl methacrylate/butyl methacrylate copolymer, and the like.

As for the compounds having a vinyloxy group suitable for use in the invention, examples thereof include the compounds described in the publication of JP-A No. 2002-29162. Specific examples thereof include tetramethylene glycol divinyl ether, trimethylolpropane trivinyl ether, tetraethylene glycol divinyl ether, pentaerythritol divinyl ether, pentaerythritol trivinyl ether, pentaerythritol tetravinyl ether, 1,4-bis {2-(vinyloxy)ethyloxy} benzene, 1,2-bis {2-(vinyloxy)ethyloxy} benzene, 1,3-bis {2-(vinyloxy)ethyloxy} benzene, 1,3,5-tris {2-(vinyloxy)ethyloxy} benzene, 4,4'-bis {2-(vinyloxy)ethyloxy} biphenyl, 4,4'-bis {2-(vinyloxy)ethyloxy} diphenyl ether, 4,4'-bis {2-(vinyloxy)ethyloxy} diphenylmethane, 1,4-bis {2-(vinyloxy)ethyloxy} naphthalene, 2,5-bis 12-(vinyloxy)ethyloxy) furan, 2,5-bis {2-(vinyloxy)ethyloxy thiophene, 2,5-bis {2-(vinyloxy)ethyloxy} imidazole, 2,2-bis[4-{2-(vinyloxy)ethyloxy}phenyl]propane {bis(vinyloxyethyl)ether of bisphenol A}, 2,2-bis {4-(vinyloxymethyloxy)phenyl} propane, 2,2-bis {4-(vinyloxy)phenyl} propane and the like, without being limited to these.

The compound having an epoxy group suitable for use in the invention is preferably a compound having two or more epoxy groups, and examples thereof include a glycidyl ether compound and a prepolymer thereof, which can be obtained by a reaction of polyhydric alcohol or polyvalent phenol with epichlorohydrin, and also a polymer or a copolymer of glycidyl acrylate or glycidyl methacrylate.

Specific examples thereof include propylene glycol diglycidyl ether, tripropylene glycol diglycidyl ether, polypropylene glycol diglycidyl ether, neopentyl glycol diglycidyl ether, trimethylolpropane triglycidyl ether, a diglycidyl ether of hydrogenated bisphenol A, hydroquinone diglycidyl ether, resorcinol diglycidyl ether, a diglycidyl ether or epichlorohydrin adduct of bisphenol A, a diglycidyl ether or epichlorohydrin adduct of bisphenol F, a diglycidyl ether or epichlorohydrin adduct of halogenated bisphenol A, a diglycidyl ether or epichlorohydrin adduct of biphenyl type bisphenol, a glycidyl etherified product of a novolak resin, a methyl methacrylate/glycidyl methacrylate copolymer, an ethyl methacrylate/glycidyl methacrylate copolymer, and the like.

Examples of the commercially available product of this compound include EPIKOTE1001 (molecular weight: about 900, epoxy equivalent: from 450 to 500), EPIKOTE 1002 (molecular weight: about 1,600, epoxy equivalent: from 600 to 700), EPIKOTE 1004 (molecular weight: about 1,060, epoxy equivalent: from 875 to 975), EPIKOTE 1007 (molecular weight: about 2,900, epoxy equivalent: 2,000), EPIKOTE 1009 (molecular weight: about 3,750, epoxy equivalent: 3,000), EPIKOTE 1010 (molecular weight: about 5,500, epoxy equivalent: 4,000), EPIKOTE 1100L (epoxy equivalent: 4,000), EPIKOTE YX31575 (epoxy equivalent: 1,200), all manufactured by Japan Epoxy Resin Co., Ltd., SUMIEPOXY ESCN-195XHN, ESCN-195XL, ESCN-195XF, all manufactured by Sumitomo Chemical Co., Ltd., and the like.

As for the isocyanate compound suitable for the invention, examples thereof include tolylene diisocyanate, diphenylmethane diisocyanate, polymethylene polyphenyl polyisocyanate, xylylene diisocyanate, naphthalene diisocyanate, cyclohexanephenylene diisocyanate, isophorone diisocyanate, hexamethylene diisocyanate, cyclohexyl diisocyanate, and a compound resulting from blocking of these compounds with alcohol or amine.

As for the amine compound suitable for the invention, examples thereof include ethylenediamine, diethylenetriamine, triethylenetetramine, hexamethylenediamine, propylenediamine, polyethyleneimine and the like.

As for the compound having a hydroxyl group suitable for the invention, examples thereof include compounds having a terminal methylol group, polyhydric alcohols such as pentaerythritol and the like, bisphenol·polyphenols, or the like.

As for the compound having a carboxyl group suitable for the invention, examples thereof include aromatic polyvalent carboxylic acids such as pyromellitic acid, trimellitic acid and phthalic acid, and aliphatic polyvalent carboxylic acids such as adipic acid and the like.

As for the compound having an acid anhydride for the invention, examples thereof include pyromellitic acid anhydride, benzophenonetetracarboxylic acid anhydride and the like.

As the method of microencapsulating the compound having a thermoreactive group, any known method can be employed. Examples thereof include the method of preparing microcapsules such as the method of utilizing coacervation as described in the specifications of USP Nos. 2800457 and 2800458; the interfacial polymerization method as described in the specifications of GBP No. 990443 and USP No. 3287154, and the publications of JP-B Nos. 38-19574, 42-446 and 42-711; the method of polymer precipitation as described in the specifications of USP Nos. 3418250 and 3660304; the method of using the isocyanate polyol wall material as described in the specification of USP No. 3796669; the method of using the isocyanate wall material as described in the specification of USP No. 3914511; the method of using the wall-forming materials of the urea-formaldehyde system or the urea-formaldehyde-resorcinol system as described respectively in the specifications of USP Nos. 4001140, 4087376 and 4089802; the method of using the wall materials such as melamine-formaldehyde resin, hydroxycellulose or the like as described in the specification of USP No. 4025445; the in situ monomer polymerization method as described respectively in the publications of JP-B Nos. 36-9163 and 51-9079; the method of spray-drying as described in the specifications of GBP No. 930422 and USP No. 3111407; the method of electrolytic dispersion cooling as described in the specifications of GBP Nos. 952807 and 967074; and the like. However the method is not limited to these.

A water-soluble polymer can be used as a dispersing agent for stably dispersing microcapsules into water medium. Exampples of the water-soluble polymer include polyvinyl alcohol and a modified compound thereof, polyacrylic acid amide and a derivative thereof, an ethylene/vinyl acetate copolymer, a styrene/anhydrous maleic acid copolymer, an ethylene/anhydrous maleic acid copolymer, an isobutylene/anhydrous maleic acid copolymer, a polyvinylpyrrolidone, ethylene/acrylic acid copolymer, a vinyl acetate/acrylic acid copolymer, carboxymethyl cellulose, methyl cellulose, casein, gelatin, a starch derivative, gum Arabic, sodium alginate and the like. It is preferable that the water-soluble polymer is unreactive or scarcely reactive with isocyanate. For example, it is preferable that a compound such as gelatin having a reactive amino group within the molecule chain is inactivate beforehand.

The wall of the microcapsules used in the invention preferably has a three-dimensional crosslinked structure and the property of swelling in a solvent. From this point of view, the wall material for the microcapsules is preferably polyurea, polyurethane, polyester, polycarbonate, polyamide and a mixture thereof, and particularly preferably polyurea and polyurethane. Into the outer wall of the microcapsule, the compound having a thermoreactive group may be introduced.

The average particle size of the microcapsules is preferably from 0.01 to 3.0 µm, more preferably from 0.05 to 2.0 µm, and particularly preferably from 0.10 to 1.0 µm. Within these ranges, good resolution and stability over time can be obtained.

Such microcapsules may or may not coalesce with each other upon application of heat. For example, microcapsule encapsulated compounds exuded from the capsule surface or out of the microcapsule, or penetrated into the microcapsule outer wall may undergo a chemical reaction upon application of heat after coating. They may also react with added hydrophilic resin or an added low-molecular-weight compound. Functional groups may be introduced into two or more kinds of microcapsules such that each kind of microcapsule has a different functional group which is thermally reacted with another functional group. Therefore, it is preferable but not indispensable, in respect of image formation, that microcapsules coalesce with each other upon application of heat.

When using either polymer particles or microcapsules, the amount added to the image recording layer is preferably 50% by mass or more, and more preferably 70 to 98% by mass, in terms of solid content, based on the total solid content of the image recording layer. Within these ranges, good image forming and good printing durability can be attained.

When incorporating the microcapsules in the hydrophilic film having functions as an image recording layer in the planographic printing plate precursor of the invention, a solvent which dissolves the compound contained in the microcapsules and swells the outer wall material may be added to the microcapsule-dispersing solvent. By using such solvent, the incorporated compound having a thermoreactive group being dispersed out of the microcapsule is accelerated. Such solvent may be selected depending on the microcapsule-dispersion medium, the constructive material and wall thickness of the microcapsule wall, and the compound contained in the microcapsule, however, it may be easily selected from a large number of commercially available solvents. For example, in the case of a water-dispersible microcapsule comprising a crosslinked polyurea or polyurethane wall, preferred examples of the solvent include alcohols, ethers, acetals, esters, ketones, polyhydric alcohols, amides, amines, fatty acids and the like.

Specific examples thereof include methanol, ethanol, tertiary butanol, n-propanol, tetrahydrofurane, methyl lactate, ethyl lactate, methyl ethyl ketone, propylene glycol monomethyl ether, ethylene glycol diethyl ether, ethylene glycol monomethyl ether, γ-butyllactone, N,N-dimethylformamide, N,N-dimethylacetamide and the like, but the invention is not limited thereto. These solvents may be used in combination of two or more thereof. A solvent which does not dissolve in the microcapsule-dispersing solution but dissolves when mixed with the above-described solvent, may also be used.

The amount of the added solvent is determined by the combination of raw materials, however, usually, the amount of the solvent added is effectively from 5 to 95 % by mass, preferably from 10 to 90% by mass, and more preferably from 15 to 85% by mass, based on the coating liquid.

### <Infrared Absorbent (E) >

In the case of image forming the planographic printing plate precursor of the present invention using, as a light source, a laser of emitting an infrared ray at 760 to 1,200 nm, it is preferable to contain an infrared absorbent in the hydrophilic film in the viewpoint of improving recording-sensitivity. The infrared absorbent has a function of converting the absorbed infrared ray into heat. Due to the generated heat, thermal decomposition of a compound capable of forming hydrophobic area, thermal lamination of a polymer particle or change in compound structure may be generated, thus forming a hydrophobic area. Any known pigment, dye, colorant or metallic particles may be used as the infrared absorber, as long as it has an absorption peak at a wavelength in a range of 760 to 1,200 nm.

The dye may be selected from commercially available dyes and known dyes described in e.g. "Senryo Binran" (Dye Handbook) (published in 1970 and compiled by Society of Synthetic Organic Chemistry). Examples of such dyes include azo dyes, metal complex salt azo dyes, pyrazolone azo dyes, naphthoquinone dyes, anthraquinone dyes, phthalocyanine dyes, carbonium dyes, quinone imine dyes, methine dyes, cyanine dyes, squarylium dyes, pyrylium salts and metal thiolate complexes.

Preferable examples of the dyes include cyanine dyes described in JP-A Nos. 58-125246, 59-84356, 60-78787 etc., methine dyes described in JP-A Nos. 58-173696, 58-181690, 58-194595 etc., naphthoquinone dyes described in JP-A Nos. 58-112793, 58-224793, 59-48187, 59-73996, 60-52940, 60-63744 etc., squarylium dyes described in JP-A No. 58-112792 etc., and cyanine dyes described in UK Patent No. 434,875.

Near infrared ray absorbing sensitizers described in US Patent No. 5,156,938 are also preferable. Also preferably used are substituted aryl benzo(thio) pyrylium salts described in US Patent No. 3,881,924, trimethine thiapyrylium salts described in JP-A No. 57-142645 (US Patent No. 4,327,169), pyrylium compounds described in JP-A Nos. 58-181051, 58-220143, 59-41363, 59-84248, 59-84249, 59-146063, and 59-146061, cyanine dye described in JP-A No. 59-216146, pentamethine thiopyrylium salts described in US Patent No. 4,283,475, and pyrylium compounds described in JP-B Nos. 5-13514 and 5-19702. Other preferable examples of the dyes include the near infrared ray absorbing dyes of formulae (I) and (II) described in US Patent No. 4,756,993.

Other preferable examples of the infrared absorbing dye in the invention include specific indolenine cyanine dyes described in JP-A No. 2002-278057, as shown below.

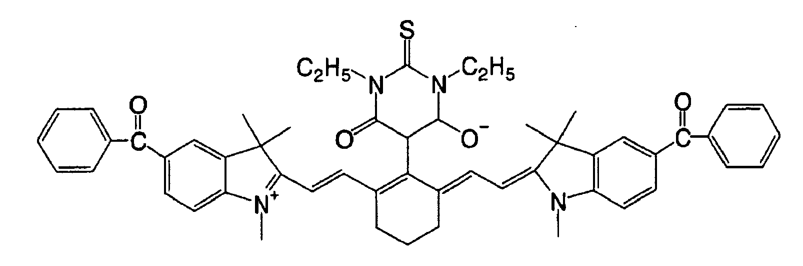

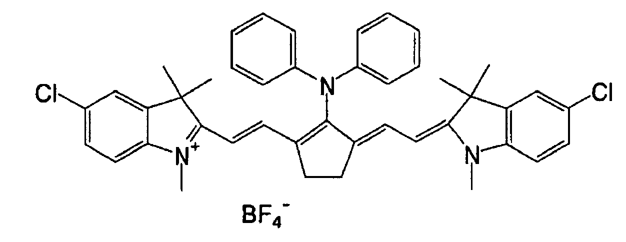

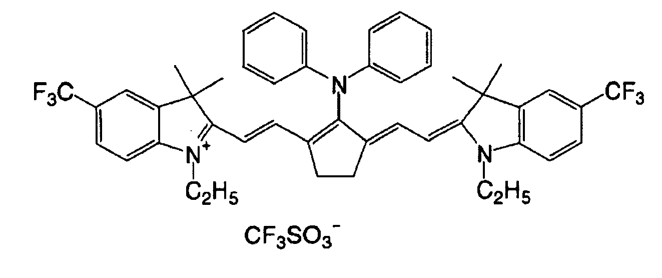

Particularly preferable among these dyes are cyanine dyes, squarylium dyes, pyrylium salts, nickel-thiolate complexes and indolenine cyanine dyes. Cyanine dyes and indolenine cyanine dyes are more preferable, and cyanine dyes represented by the following formula (i) are still more preferable:

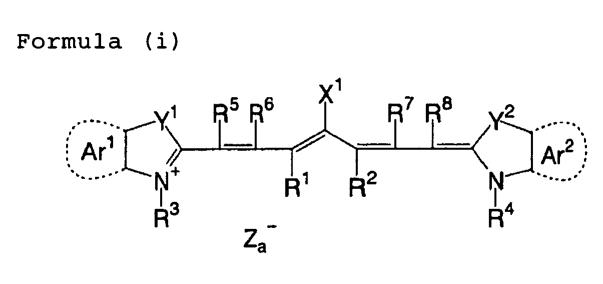

In the formula (i), X¹ represents a hydrogen atom, halogen atom, -NPh₂, X²-L¹ or the group shown below.

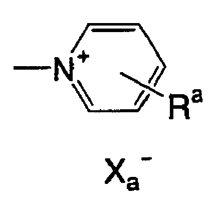

Xa⁻ represents a counter-anion. R^{a} represents a substituent selected from a hydrogen atom, an alkyl group, an aryl group, a substituted or unsubstituted amino group, and a halogen atom.

X² represents an oxygen atom, a nitrogen atom or sulfur atom, and L¹ represents a C₁₋₁₂ hydrocarbon group, an aromatic ring containing a heteroatom, or a C₁₋₁₂ hydrocarbon group containing a heteroatom. The heteroatom refers to N, S, O, halogen atom or Se.

R¹ and R² each independently represent a C₁₋₁₂ hydrocarbon group. From the viewpoint of the storage stability of the recording layer coating liquid, each of R¹ and R² is preferably a hydrocarbon group containing 2 or more carbon atoms. In a preferable embodiment, R¹ and R² are bound to each other to form a 5- or 6-memberred ring.

Ar¹ and Ar² may be the same as or different from each other. Ar¹ and Ar² each independently represent an aromatic hydrocarbon group which may have a substituent. The aromatic hydrocarbon group is preferably a benzene ring or naphthalene ring. The substituent is preferably a hydrocarbon group containing 12 or less carbon atoms, a halogen atom or an alkoxy group containing 12 or less carbon atoms. Y¹ and Y² may be the same as or different from each other, and each independently represent a sulfur atom or a dialkyl methylene group containing 12 or less carbon atoms. R³ and R⁴ may be the same as or different from each other, and each independently represent a hydrocarbon group containing 20 or less carbon atoms, which may have a substituent. The substituent is preferably an alkoxy group containing 12 or less carbon atoms, a carboxyl group or a sulfo group. R⁵, R⁶, R⁷ and R⁸ may be the same as or different from each other, and each independently represent a hydrogen atom or a hydrocarbon group containing 12 or less carbon atoms. Each of R⁵, R⁶, R⁷ and R⁸ is preferably a hydrogen atom because the starting material is easily available. Za⁻ represents a counter anion. However, when the cyanine dye represented by the formula (i) has an anionic substituent in its structure and thus neutralization of the charge is not necessary, Za⁻ can be omitted. From the viewpoint of the storage stability of the recording layer coating liquid, Za⁻ is preferably a halogen ion, a perchlorate ion, a tetrafluoroborate ion, a hexafluorophosphate ion or a sulfonate ion, particularly preferably a perchlorate ion, a hexafluorophosphate ion or an aryl sulfonate ion.

As examples of the cyanine dyes represented by the formula (i), the cyanine dyes described in paragraph Nos. 0017 to 0019 of JP A No. 2001-133969 may be cited.

Other preferable examples of the infrared absorbing agent in the invention include specific indolenine cyanine dyes described in JP-A No. 2002-278057.

The pigment which can be used in the invention includes commercially available pigments and the pigments described in Color Index (C. I.) Handbook, "Saishin Ganryo Binran" (Newest Dye Handbook) (published in 1977 and compiled by Japanese Society of Pigment Technology), "Saishin Ganryho Oyo Gijyutsu" (Newest Pigment Applied Technology) (published in 1986 by CMC), and "Insatsu Inki Gijyutsu" (Printing Ink Technology) (published in 1984 by CMC).

Examples of usable pigments include black pigments, yellow pigments, orange pigments, brown pigments, red pigments, violet pigments, blue pigments, green pigments, fluorescent pigments, metallic powder pigments, and other pigments such as polymer-binding dyes. Specific examples thereof include insoluble azo pigments, azo lake pigments, condensed azo pigments, chelate azo pigments, phthalocyanine pigments, anthraquinone pigments, perylene pigments, perinone pigments, thioindigo pigments, quinacridone pigments, dioxazine pigments, isoindolinone pigments, quinophthalone pigments, dyed lake pigments, azine pigments, nitroso pigments, nitro pigments, natural pigments, fluorescent pigments, inorganic pigments, and carbon black. Carbon black is preferable.

The pigments may or may not be subjected to surface treatment before use. The method of surface treatment may be a method of coating the pigment surface with resin or wax, a method of allowing a surfactant to adhere to the pigment surface, or a method of binding a reactive material (e.g., a silane coupling agent, an epoxy compound, a polyisocyanate etc.) onto the pigment surface. These surface treatment methods are described in "Kinzoku Sekken No Seishitsu To Oyo" (Properties and Application of Metallic Soap) (Sachi Shobo), "Insatsu Inki Gijyutsu" (Printing Ink Technology) (published in 1984 by CMC Shuppan) and "Saishin Ganryho Oyo Gijyutsu" (Newest Pigment Applied Technology) (published in 1986 by CMC Shuppan).

The particle size of the pigment is preferably in the range 0.01 to 10 µm, more preferably 0.05 to 1 µm, still more preferably 0.1 to 1 µm. In this range, the excellent dispersion stability of the pigment in the image recording layer coating liquid and the excellent uniformity of the image recording layer can be achieved.

The method of dispersing the pigment may be selected from known dispersion techniques used in production of inks or toners. Examples of the dispersing machine include a supersonic dispersing device, sand mill, attritor, pearl mill, super mill, ball mill, impeller, disperser, KD mill, colloid mill, dynatron, triple roll mill, and press kneader. Details of the dispersing is described in "Saishin Ganryho Oyo Gijyutsu" (Newest Pigment Applied Technology) (published in 1986 by CMC Shuppan).

The metal particles used in the invention may be particles of a transition metal oxide, metal (belonging to Group 2 to 12 of a periodic table) sulfide, metal (belonging to Group 3 to 12 of a periodic table) nitride, a metal (belonging to Group 2 to 12 of a periodic table) or an alloy thereof.

Examples of the transition metal oxides include oxides of iron, cobalt, chrome, manganese, nickel, molybdenum, tellurium, niobium, yttrium, zirconium, bismuth, ruthenium, vanadium or the like. Further, oxides of zinc, mercury, cadmium, silver or copper may also be used in the invention, although these may not be classified as transition metals in some classifications. Among these, preferable examples of metal oxides include FeO, Fe₂O₃, Fe₃O₄, CoO, Cr₂O₃, MnO₂, ZrO₂, Bi₂O₃, CuO, CuO₂, AgO, PbO, PbO₂, VOₓ (x = 1 to 5). VOₓ includes black VO, V₂O₃, VO₂ or brown V₂O₅.

Preferable examples of inorganic metal oxide include TiOₓ (x = 1.0 to 2.0), SiOₓ (x = 0.6 to 2.0), AlOₓ (x = 1.0 to 2.0). As for TiOₓ (x = 1.0 to 2.0), examples thereof include black TiO, dark purple Ti₂O₃ and TiO₂ exhibiting various colors depending on the crystal forms and impurities. As for SiOₓ (x = 0.6 to 2.0), examles thereof include SiO, Si₃O₂, colorless SiO₂ and SiO₂ exhibiting purple, blue, red or the like color depending on coexisting substances. Further, as for AlOₓ (x = 1.5), examples thereof include colorless corundum and corundum exhibiting red, blue or green color or the like depending on coexisting substances. These are also included in preferable metal oxides.

The metal oxide, in the case of a low order oxide of polyvalent metal, may be a photothermal converter and may also be a self-exothermic-type oxidation substance. In this case, it is preferable because in addition to the energy absorbed from light, heat generated as a result of self-exothermic reaction can be used. Examples of low order oxides of metal include low order oxides of metal such as Fe, Co, Ni or the like. Specific examples include ferrous oxide, ferrosoferric oxide, titanium monoxide, stannous oxide, chromium monoxide and the like. Among these, ferrous oxide, ferrosoferric oxide and titanium monoxide are preferable.

Whether self-exothermic reaction is occurred or not can be confirmed easily using differential thermal analysis and thermogravimetry (TG/DTA). To the differential thermal analysis and thermogravimetry, a self-exothermic reaction substance is inserted, and the temperature is elevated at constant-speed to observe the undergoing exothermic reaction by the appearing of an exothermic peak at a temperature. In the case of using oxidation reaction of a metal or a low order metal oxide as self-exothermic reaction, exothermic peak appearing as well as weight increase in thermogravimetry was observed. Although being repeated, by using the energy generated from the self-exothermic reaction in addition to the energy generated by the photothermal conversion, compared to the conventional result, even more thermal energy per unit radiant light may be used continuously, thereby improving sensitivity.

In the case where photothermal convertible fine particles contain a metal sulfide, the metal sulfide is preferably a sulfide of heavy metal such as a transition metal or the like. Among these, preferable examples thereof include sulfides of iron, cobalt, chromium, manganese, nickel, molybdenum, tellurium, strontium, tin, copper, silver, lead or cadmium. Particularly, silver sulfide, iron sulfide and cobalt sulfide are preferable.

In the case where photothermal convertible fine particles contain a metal nitride, the metal nitride is preferably an azid compound of metals. Particularly, an azid compound of copper, silver or tin is preferable. Such an azid compound is also a self-exothermic compound which generates heat by photodegradation. Other preferable examples of inorganic metal nitride include TiNₓ (x = 1.0 to 2.0), SiNₓ (x = 1.0 to 2.0), AlNₓ (x = 1.0 to 2.0), and the like. As for TiNₓ (x = 1.0 to 2.0), examples thereof include bronze TiN and brown TiNₓ (x = 1.3). As for SiNₓ (x = 1.0 to 2.0), examples thereof include Si₂N₃, SiN and Si₃N₄. As for AlNₓ (x = 1.0 to 2.0), examples thereof include AIN and the like.

Any of the above described metal oxide, sulfide and nitride may be obtained via conventional preparation method. Further, there are many commercially available products in the name of Titanium Black, Black Iron, Red Molybdenum, Emerald Green, Cadmium Red, Cobalt Blue, Prussian Blue, Ultramarine and the like.

As for the particle size of these hydrophilic metal compounds, the optimal particle size varies depending on a refractive index or an absorption coefficient of the materials constituting the particles, but it is generally 0.005 to 5 µm, and preferably 0.01 to 3 µm. If the particle size is too small or too big, inefficiency of light absorption is caused due to light scattering and interfacial reflection of the particles.

Most of the metal particles are capable of photothermal conversion as well as self-exothermic reaction, and thus after generating heat by absorbing light, the heat is used as a trigger for the exothermic reaction to supply a larger amount of heat.

Examples of the particle include fine particles of Mg, Al, Si, Ti, V, Cr, Mn, Fe, Co, Ni, Cu, Zn, Ga, Ge, Y, Zr, Nb, Mo, Tc, Ru, Pd, Ag, Cd, In, Sn, Sb, Hf, Ta, W, Re, Os, Ir, Pt, Au, Pb or the like. These fine metal particles are capable of photothermal conversion as well as self-exothermic raection. Among these, the fine metal particles which are easily undergo exothermic reaction such as oxidation reaction and the like by the thermal energy obtained via photothermal conversion of the absorbed light are preferable. Specifically, A1, Si, Ti, V, Cr, Mn, Fe, Co, Ni, Cu, Zn, Y, Zr, Mo, Ag, In, Sn and W are preferable. Among these, particularly the ones having high absorbance of radiant light and generating high thermal energy by self-exothermic reaction, such as Fe, Co, Ni, Cr, Ti and Zr are preferable.

These metal particles may be composed of a metal as well as an alloy of two or more components. Also, the particles may be composed of a metal and the above described metal oxides, nitrides, sulfides, carbides or the like. Metal particles composed of a metal generate higher thermal energy by self-exothermic reaction such as oxidation, but handling thereof in the air is complicated and there may be a natural inflammation when contacted with air. It is preferable that such metal particles are covered with metal oxides, nitrides, sulfides, carbides or the like in the thickness of several nm from the surface. The particle size thereof is preferably 10 µm or less, mroe preferably 0.005 to 5 µm, and even more preferably 0.01 to 3 µm. With the particle size of 0.01 µm or more, the perticles can be easily dispersed, while with the particle size of 10 µm or less, excellent resolution of the printed matter can be attained.

The infrared absorbent may be added to the same layer as other components, or a different layer may be formed and the infrared absorbent may be added thereto. It is preferable that the infrared absorbent is added such that the absorbance of the hydrophilic film (image recording layer) in a planographic printing plate precursor, at the absorption maximum in the range of wavelengths of from 760 nm to 1200 nm, is in a range of from 0.3 to 1.2, and more preferably from 0.4 to 1.1, by a reflection measurement method. Within these ranges, the infrared absorbent generates heat by infrared exposure in the exposure area, and a thermodegradable compound is degraded so that conversion of hydrophilicity to hydrophobicity occurs, or a reaction for converting hydrophilicity to hydrophobicity occurs. Further, in the case of using the polymerizable compound and the polymerization initiator in combination, a polymerization reaction in the image recording layer progresses and good film strength in the image area and good adhesion to the support can be obtained. By such, a good hydrophobized area may be formed on the hydrophilic layer, and thus the hydrophobized area, that is, the image area, may be formed.

The absorbance of the image recording layer may be controlled by the content of an infrared absorbent and the thickness of the image recording layer. The measurement of the absorbance may be carried out by a conventional method. As for the measurement method, examples thereof include a method for measuring reflection density of the image recording layer having a thickness appropriately predetermined within a range such that the dry coated amount is in a necessary range for planographic printing plate, provided on a reflective support such as aluminum, using an optical densimeter; and a method for measuring with a spectrophotometer by reflection using an integrating sphere.

Further, the content of an infrared absorbent (as solid content) is preferably in a range of 0.1 to 30% by mass, the content of a dye is preferably in a range of 1 to 15% by mass, the content of a pigment is preferably in a range of 0.1 to 25 % by mass and the content of metal (compound) particles is preferably in a range of 0.1 to 25% by mass, as a solid content, based on the hydrophilic film.

### <Surfactant>

In the invention, the image recording layer preferably includes a surfactant in order to improve the surface property of the coated layer. The surfactant may be a nonionic surfactant, an anionic surfactant, a cationic surfactant, an amphoteric surfactant, or a fluorine-based surfactant. Only a single surfactant may be used, or two or more surfactants may be used.

The nonionic surfactant used in the invention is not particularly limited, and may be a conventionally known nonionic surfactant. Examples thereof include polyoxyethylene alkyl ethers, polyoxyethylene alkyl phenyl ethers, polyoxyethylene polystyryl phenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylene castor oils, polyoxyethylene glycerin fatty acid partial esters, fatty acid diethanol amides, N,N-bis-2-hydroxyalkyl amines, polyoxyethylene alkyl amine, triethanol amine fatty acid esters, trialkyl amine oxides, polyethylene glycol, and polyethylene glycol-polypropylene glycol copolymers.

The anionic surfactant used in the invention is not particularly limited, and may be a conventionally known anionic surfactant. Examples thereof include fatty acid salts, abietates, hydroxyalkane sulfonates, alkane sulfonates, dialkylsulfosuccinic ester salts, linear alkyl benzene sulfonates, branched alkyl benzene sulfonates, alkyl naphthalene sulfonates, alkyl phenoxy polyoxyethylene propyl sulfonates, polyoxyethylene alkyl sulfophenyl ether salts, N-methyl-N-oleyl taurine sodium salt, N-alkyl sulfosuccinic monoamide disodium salt, petroleum sulfonates, sulfated tallow oil, sulfuric ester salts of alkyl esters of fatty acids, alkyl sulfuric ester salts, polyoxyethylene alkyl ether sulfuric ester salts, fatty acid monoglyceride sulfuric ester salts, polyoxyethylene alkyl phenyl ether sulfuric ester salts, polyoxyethylene styryl phenyl ether sulfuric ester salts, alkyl phosphoric ester salts, polyoxyethylene alkyl ether phosphoric ester salts, polyoxyethylene alkyl phenyl ether phosphoric ester salts, partially saponified styrene-maleic anhydride copolymers, partially saponified olefin-maleic anhydride copolymers and naphthalene sulfonate formalin condensates.

The cationic surfactant used in the invention is not particularly limited, and may be a conventionally known cationic surfactant. Examples thereof include alkyl amine salts, quaternary ammonium salts, polyoxyethylene alkyl amine salts and polyethylene polyamine derivatives.

The amphoteric surfactant used in the invention is not particularly limited, and may be a conventionally known amphoteric surfactant. Examples thereof include carboxy betaines, aminocarboxylic acids, sulfobetaines, aminosulfates and imidazolines.

Examples of the surfactant further includes the surfactants obtained by replacing the polyoxyethylene in the above surfactants by a polyoxyalkylene such as a polyoxymethylene, a polyoxypropylene, or a polyoxybutylene..

Fluorine-based surfactants containing perfluoroalkyl groups are further preferable. Examples of the fluorine-based surfactants include: anionic surfactants such as perfluoroalkyl carboxylates, perfluoroalkyl sulfonates and perfluoroalkyl phosphates; amphoteric surfactants such as perfluoroalkyl betaine; cationic surfactants such as perfluoroalkyl trimethyl ammonium salts; and nonionic surfactants such as perfluoroalkyl amine oxides, perfluoroalkyl ethylene oxide adducts, oligomers each having a perfluoroalkyl group and a hydrophilic group, oligomers each having a perfluoroalkyl group and a lipophilic group, oligomers each having a perfluoroalkyl group, a hydrophilic group, and a lipophilic group, and urethanes each having a perfluoroalkyl group and a lipophilic group. The fluorine-based surfactants described in JP-A Nos. 62-170950, 62-226143 and 60-168144 are also preferable.

Only a single surfactant may be used or two or more surfactants may be used.

The content of the surfactant is preferably 0.001 to 10 % by mass, more preferably 0.01 to 5 % by mass, based on the total solid content of the hydrophilic film.

### <Colorant>

In the invention, various compounds other than the above-inentioned compounds may be further added if necessary. For example, dyes having large absorption in the visible light range can be used as colorants for an image. Specific examples of the colorants include Oil Yellow #101, Oil Yellow #103, Oil Pink #312, Oil Green BG, Oil Blue BOS, Oil Blue #603, Oil Black BY, Oil Black BS, Oil Black T-505 (which are manufactured by Orient Chemical Industries, Ltd.), Victoria Pure Blue, Crystal Violet (CI42555), Methyl Violet (CI42535), Ethyl Violet, Rhodamine B (CI145170B), Malachite Green (CI42000), Methylene Blue (CI52015), and the dyes disclosed in JP-A No. 62-293247. The colorants are not limited to dyes and may be selected from pigments such as phthalocyanine pigments, azo pigments, carbon black and titanium oxide.

The addition of the colorants is preferable since the addition enables easy differentiation between the image area and the non-image area after image formation. The amount of the colorant to be added is 0.01 to 10% by mass based on the total solid content of the image recording materials.

### <Printing-out agent>

A compound whose color can be changed by an acid or by a radical may be added to the image recording layer in order to form a printout image. Such a compound may be, for example, a colorant such as a diphenyl methane colorant, a triphenyl methane colorant, a thiazine colorant, an oxazine colorant, a xanthene colorant, an anthraquinone colorant, an iminoquinone colorant, an azo colrant, or an azomethine colorant.

Specific examples thereof include dyes such as Brilliant Green, Ethyl Violet, Methyl Green, Crystal Violet, Basic Fuchsin, Methyl Violet 2B, Quinaldine Red, Rose Bengal, Metanil Yellow, Thymol Sulfophthalein, Xylenol Blue, Methyl Orange, Paramethyl Red, Congo Red, Benzopurprin 4B, α-Naphthyl Red, Nile Blue 2B, Nile Blue A, Methyl Violet, Malachite Green, Parafuchsin, Victoria Pure Blue BOH (manufactured by Hodogaya Kagaku Co., Ltd.), Oil Blue #603 (manufactured by Orient Chemical Industries, Ltd.), Oil Pink #312 (manufactured by Orient Chemical Industries, Ltd.), Oil Red 5B (manufactured by Orient Chemical Industries, Ltd.), Oil Scarlet #308 (manufactured by Orient Chemical Industries, Ltd.), Oil Red OG (manufactured by Orient Chemical Industries, Ltd.), Oil Red RR (manufactured by Orient Chemical Industries, Ltd.), Oil Green #502 (manufactured by Orient Chemical Industries, Ltd.), Spirone Red BEH Special (manufactured by Hodogaya Kagaku Co., Ltd.), m-Cresol Purple, Cresol Red, Rhodamine B, Rhodamine 6G, Sulforhodamine B, Auramine, 4-p-diethylaminophenyl iminonaphthoquinone, 2-carboxyanilino-4-p-diethylaminophenyl iminonaphthoquinone, 2-carboxystearylamino-4-p-N,N-bis(hydroxyethyl) amino-phenyliminonaphthoquinone, 1-phenyl-3-methyl-4-p-diethylaminophenylimino-5-pyrazolone and 1-β-naphthyl-4-p-diethylaminophenylimino-5-pyrazolone, and leuco dyes such as p,p',p"-hexamethyl triaminophenyl methane (Leuco Crystal Violet) and Pergascript Blue SRB (manufactured by Ciba-Geigy).

In addition to those described above, preferable examples of the printout agent further include leuco dyes known as materials for thermal sensitive paper and pressure sensitive paper. Specific examples thereof include crystal violet lactone, malachite green lactone, benzoyl leucomethylene blue, 2-(N-phenyl-N-methylamino)-6-(N-p-tolyl-N-ethyl) amino-fluoran, 2-anilino-3-methyl-6-(N-ethyl-p-toluidino) fluoran, 3,6-dimethoxy fluoran, 3-(N,N-diethylamino)-5-methyl-7-(N,N-dibenzylamino)-fluoran, 3-(N-cyclohexyl-N-methylamino)-6-methyl-7-anilinofluoran, 3-(N,N-diethylamino)-6-methyl-7-anilinofluoran, 3-(N,N-diethylamino)-6-methyl-7-xylidinofluoran, 3-(N,N-diethylamino)-6-methyl-7-chlorofluoran, 3-(N,N-diethylamino)-6-methoxy-7-aminofluoran, 3-(N,N-diethylamino)-7-(4-chloroanilino) fluoran, 3-(N,N-diethylamino)-7-chlorofluoran, 3-(N,N-diethylamino)-7-benzyl aminofluoran, 3-(N,N-diethylamino)-7,8-benzofluoran, 3-(N,N-dibutylamino)-6-methyl-7-anilinofluoran, 3-(N,N-dibutylamino)-6-methyl-7-xylidinofluoran, 3-piperidino-6-methyl-7-anilinofluoran, 3-pyrrolidino-6-methyl-7-anilinofluoran, 3,3-bis(1-ethyl-2-methylindol-3-yl) phthalide, 3,3-bis(1-n-butyl-2-methylindol-3-yl) phthalide, 3,3-bis(p-dimethylaminophenyl)-6-dimethyl amino phthalide, 3-(4-diethylamino-2-ethoxyphenyl)-3-(1-ethyl-2-methylindol-3-yl)-4-phthalide, and 3-(4-diethylaminophenyl)-3-(1-ethyl-2-methylindol-3-yl) phthalide.

The amount of the dye whose color is changed by an acid or by a radical is 0.01 to 10 % by mass based on the total solid content in the hydrophilic film.

### <Inorganic fine particles>

In the invention, the image recording layer may further include inorganic fine particles in order to improve the strength of the cured film, hydrophilicity and water holding property of the hydrophilic film.

Examples of the inorganic fine particles include, for example, silica, alumina, magnesium oxide, titanium oxide, magnesium carbonate, calcium alginate and mixtures thereof. Even if an inorganic fine particle cannot convert light to heat, the inorganic fine particle may be used for reinforcement of the coating film and improvement of the interfacial adhesiveness by surface roughening.

The average particle size of the inorganic fine particle is preferably 5 nm to 10 µm, more preferably 0.5 µm to 3 µm. When the average particle diameter is in the above range, the inorganic fine particles can be dispersed stably in the image recording layer, whereby excellent film strength of the image recording layer is obtained and a highly hydrophilic non-image area which is hardly blemished during printing is obtained.

The inorganic fine particles described above are easily available as commercially available products such as colloidal silica dispersions.

The content of the inorganic fine particles is preferably 20 % by mass or lower, more preferably 10 % by mass or lower, based on the total solid content of the image recording layer.

### <Formation of the crosslinked hydrophilic layer>

In the invention, the hydrophilic film (hydrophilic layer having a crosslinked structure) can be formed by dispersing or dissolving the necessary components described above in a solvent to prepare a coating liquid and then applying the coating liquid. Examples of the solvent include, but are not limited to: ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethyl urea, N-methyl pyrrolidone, dimethyl sulfoxide, sulfolane, γ-butyrolactone, toluene and water. Only a single solvent may be used or a mixture of two or more solvents may be used. The total solid content of the coating liquid is preferably 1 to 50% by mass.

In an embodiment, coating liquids each including different or overlapping components dissolved or dispersed in a same or different solvent are prepared, then the coating liquids are applied by the repetition of coating and drying to form the hydrophilic film.

The amount (in terms of the solid amount) of the crosslinked hydrophilic layer, which was formed on the support by coating and drying, may be changed in accordance with the intended use, and is generally 0.1 to 10.0 g/m², preferably 0.3 to 7.0 g/m², and more preferably 0.5 to 5.0 g/m². When the amount is in these ranges, a film with excellent hidrophilicity and film strength can be obtained.

The coating may be conducted by any of various methods whose examples include bar coating, spin coating, spray coating, curtain coating, dip coating, air knife coating, blade coating and roll coating.

By drying after coating, the crosslinking reaction proceeds to form a crosslinked hydrophilic layer. In the case of performing thermal crosslinking, there is no particular limitation to temperature condition or the like, but it is preferable to perform crosslinking at 40°C to 300°C, and in the viewpoint of crosslinkability and preparation stability, it is preferable at 60°C to 250°C.

### <Support>

The support used in the planographic printing plate precursor of the invention is not particularly limited insofar as it is a dimensionally stable plate. Examples thereof include a paper, a plastic laminated paper (e.g., polyethylene laminated paper, polypropylene laminated paper, polystyrene laminated paper etc.), a metal plate (e.g., aluminum, zinc, copper etc.), plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal etc.), a paper on which any of the above-described metals is laminated or vapor-deposited, and a plastic film on which any of the above-described metals is laminated or vapor-deposited. The support is preferably a polyester film or an aluminum plate. The aluminum plate is particularly preferable because it is excellent in dimensional stability and relatively inexpensive.

The thickness of the support is preferably 0.05 to 1.0 mm, more preferably 0.07 to 0.7 mm, and even more preferably 0.1 to 0.5 mm.

It is preferable to subject the aluminum plate to a surface treatment such as a roughening treatment or an anodizing treatment prior to use.

### <Intermediate layer>

The planographic printing plate precursor of the invention may form an intermediate layer, if necessary, in between the hydrophilic film and the support. The intermediate layer functions as a insulating layer whereby prevents heat, generated from the exposure by the infrared laser, from diffusing to the support and can be used efficiently, thus it has advantage in achieving high sensitivity. Further, in the invention, since the hydrophilic film has both of the image area and the non-image area, it is preferable that the hydrophilic film has close adherence to the support, thus it being advantageous in improvement in close adherence between the support and the hydrophilic film.

In the case of the support being a plastic film, an adhesive such as an acryl-based, urethane-based, cellulose-based, or epoxy-based adhesive may be applied on the support; or an undercoating layer as disclosed in JP-A Nos. 6-316183, 8-272088, 9-179311, 2001-199175, that is, an intermediate layer containing a homopolymer or a copolymer of polyvinyl alcohol, hydroxyalkyl acrylate or methacrylate, hydrolyzed tetra ethyl or methyl orthosilicate, and suitably further containing fine particles such as silicon dioxide and/or titanium dioxide may be provided on the support.

In the case of the metallic support, it is preferable to use an organic or inorganic resin. Such organic or inorganic resins may be selected from wide range including conventional hydrophobic polymers, hydrophilic polymers, crosslinked hydrophilic polymers, and inorganic polymers derived from a compound such as aluminum, silicon, titanium, zirconium and the like having a hydroxyl group or an alkoxy group which undergoes sol-gel transition. More preferred in the invention is a silica-containing intermediate layer.

To the intermediate layer, a hydrophilic binder polymer may be added if necessary. Specific examples of the hydrophilic binder polymer include water-soluble resins such as polyvinyl alcohol (PVA), modified PVA (for example, carboxy-modified PVA and the like), starch and its derivatives, a cellulose derivative (for example, carboxymethyl cellulose, hydroxyethyl cellulose), casein, gelatin, polyvinyl pyrrolidone, a vinyl acetate-crotonic acid copolymer, an styrene-maleic acid copolymer, polyacrylic acid and a salt thereof, polyacrylamide, and a water-soluble acryl-based copolymer containing a water-soluble acryl-based monomer such as acrylic acid, acrylamide and the like as a main component, and the like.

In the case of using silica in an intermediate layer, the molecular weight ratio of hydrophilic binder polymer relative to that of silica within the intermediate layer is preferably less than 1. The lower limit is not very important, but at least 0.2 is preferable. The molecular weight ratio of hydrophilic binder polymer relative to that of silica in a range of 0.25 to 0.5 is more preferable.

The amount of intermediate layer coating is preferably 10 mg/m² or more and preferably less than 5000 mg/m², and more preferably 50 mg/m² to 3000 mg/m². The above-described coating of the compound of the intermediate layer may be carried out with an aqueous colloidal dispersion solution in the presence of a surfactant, if necessary.

### <Surface protective layer>

The planographic printing plate precursor of the invention may include a surface protective layer (hereinafter, may referred to as "protective layer"), if necessary.

The surface of the planographic printing plate precursor is hydrophilic, thus it becomes hydrophobized by the effect of the atmospheric environment during handling before use and is easily affected by the temperature or the humidity or the mechanical scratches or stains, or the like. In general, in order to protect the surface, coating the plate surface with a coating liquid (also known as a rubber solution) is carried out during plate making process. However, by coating the protection solution during the preparation of plate precursor and forming a surface protective layer, there may be advantages in obtaining such protection from right after the preparation of the precursor, and in improving workability by reducing the work of coating the coating liquid during plate making process.

According to the invention, the exposure is usually performed in the air. The protective layer prevents low-molecular-weight compounds such as oxygen and basic substances present in the air, which inhibit the image-forming reaction occurring in the hydrophilic layer upon exposure, from being incorporated into the hydrophilic layer, thereby preventing the inhibition of the image-forming reaction upon exposure in the air. Accordingly, the property required from the protective layer is low permeability to low-molecular-weight compounds such as oxygen and the like. Further, preferred protective layer is highly transmissive to the light used for exposure, is excellent in adhesion to the hydrophilic layer, and is easily removed on the printing press. Various studies have been heretofore made on the protective layer having these properties, and such protective layers are described in detail, for example, in the specification of USP No. 3,458,311 and the publication of JP-A No. 55-49729.

The material used in the protective layer is preferably a water-soluble polymer compound having relatively high crystallinity. Specific examples thereof include water-soluble polymers such as polyvinyl alcohol, polyvinyl pyrrolidone, acidic celluloses, gelatin, gum arabic and polyacrylic acid. When polyvinyl alcohol (PVA) is used as a main component, the protective layer is optimal with respect to basic characteristics such as oxygen impermeability and removability upon development. The polyvinyl alcohol may be partially substituted by an ester, an ether or an acetal and may partially include other copolymerizable components insofar as it contains unsubstituted vinyl alcohol units which give the oxygen blocking property and water solubility required for the protective layer.

The polyvinyl alcohol may be a polyvinyl alcohol hydrolyzed at a degree of 71 to 100%, having a polymerization degree in the range of 300 to 2400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, all of which are manufactured by Kuraray Co., Ltd.

The components (the kind of PVA, additives to be used, and the like) of the protective layer, the coating amount, etc. are selected in consideration of the oxygen blocking property, removability on a printing press, fogging property, adhesiveness, flaw resistance, suppression of ablation, and the like. In general, as the degree of hydrolysis of PVA is increased (as the content of unsubstituted vinyl alcohol units in the protective layer is increased) or as the thickness of the layer is increased, the oxygen blocking property is enhanced to improve the sensitivity. However, excessive oxygen blocking property is not preferred, from a viewpoint of preventing undesired polymerization reaction during production or storage, and unnecessary fogging and line thickening upon imagewise exposure. Accordingly, the oxygen permeability A at 25°C at 1 atm is preferably 0.2 ≤ A≤ 20 (ml/m²·day).

As other components in the protective layer, glycerin, dipropylene glycol etc. can be added in an amount of a few % by mass based on the (co)polymer, in order to impart flexibility to the protective layer. Further, anionic surfactants such as sodium alkylsulfate and sodium alkylsulfonate, amphoteric surfactants such as alkylaminocarboxylates and alkylaminodicarboxylates and nonionic surfactants such as polyoxyethylene alkyl phenyl ether may be added in an amount of a few wt% based on the (co)polymer.

The thickness of the protective layer is preferably 0.05 to 5g/m², more preferably 0.1 to 3 g/m².

### < Other layers>

A backcoat can be formed on the opposite side of the support, if necessary. As for the backcoat, examples thereof include a coating layer comprising a metal oxide which can be obtained by hydrolysis and polycondensation of the organic polymer compound as described in the publication of JP A No. 5-45885, or the organic or inorganic metal compound as described in the publication of JP-A No. 6-35174. Among these, an alkoxy compound of silicon such as Si(OCH₃)₄, Si(OC₂H₅)₄, Si(OC₃H₇)₄ and Si(OC₄H₉)₄ is preferred because it is easily available at low costs and the coating layer of the metal oxide obtained therefrom has excellent hydrophilicity.

### <Curing method>

The hydrophilic film of the invention can be obtained by, after coating and drying, curing the resulting film by application of light or heat. In the case of heat curing, there is no particular limitation such as time, heat source or the like, but it is preferable to perform curing at 40°C to 300°C, and in the viewpoint of curing property and stability, it is preferable at 60°C to 250°C.

In the case of curing upon application of light, there is no particular limitation to the light source, and any wavelength of ultraviolet light, visible light, infrared light, or white light may be used.

Further, insofar as massive amount of radical can be generated, the curing reaction may be carried out in the air, or under nitrogen or argon atmosphere.

### EXAMPLES

Hereinafter, the invention will be described in detail by way of Examples, which are not intended to limit the invention in any means.

### Synthesis Example 1: Synthesis of amide macromonomer

30 g of acryl amide and 3.8 g of 3-mercapto propionic acid were dissolved in 70 g of ethanol, the temperature was increased to 60°C in a nitrogen atmosphere, and 300 mg of a thermal polymerization initiator, 2,2-azobisisobutylnitrile (AIBN), was added thereto followed by reacting for 6 hours. After the reaction, the white precipitates were filtered and washed thoroughly with methanol to obtain 30.8 g of terminal carboxylic acid prepolymer (acid value: 0.787 meq/g, molecular weight: 1.29 × 10³). 20 g of the obtained prepolymer was dissolved in 62 g of dimethylsulfoxide, and 6.71 g of glycidylmethacrylate, 504 mg of N,N-dimethyldodecylamine (catalyst) and 62.4 mg of hydroquinone (polymerization inhibitor) were added thereto followed by reacting at 140°C for 7 hours in a nitrogen atmosphere. The reaction solution was added to acetone to precipitate a polymer, and washed sufficiently to obtain 23.4 g of a terminal methacrylate acrylamide macromonomer (weight-average molecular weight: 1400). Introduction of the polymerizable group to the terminal was confirmed by peaks of methacryloyl group olefin at 6.12 and 5.70 ppm of H¹-NMR (D₂O) and reduction of acid value (0.057 meq/g).

### Synthesis Example 2: Synthesis of sulfonic acid macromonomers

147.8 g of methacrylic acid 3-sulfopropylester potassium salt, 3.82 g of mercapto propionic acid and 0.582 g of polymerization initiator, VA-044, manufactured by Wako Pure Chemical Industries Ltd. were dissolved in 151.5 g of water, and the obtained aqueous solution was added dropwise to 151.5 g of water maintained at 50°C for 2 hours in a nitrogen atmosphere. After dropwise addition, the solution was stirred at 50°C for 2 hours and at 60°C for 2 hours, and was cooled followed by slow dropwise addition to 4.5 L of acetone to precipitate a white solid product.

The obtained solid product was filtered, and dried to obtain 145 g of polymer A. The acid value was 0.086 meq/g after drying.

80 g of polymer A was dissolved in 240 g of acetone/water (1/2 by volume) solvent, and 6.17 g of α-bromomethylmethacrylate and 3.48 g of triethylamine were added thereto, followed by stirring at room temperature for 10 hours, further followed by dropwise addition to 4 L of acetone to precipitate a white solid product. The solid product thus obtained was filtered and dried to obtain 82 g of polymer B. Introduction of the polymerizable group to the terminal was confirmed by peaks resulting from the double bond at 6.36 and 6.90 ppm of H¹-NMR (D₂O) and acid value of 0.004 meq/g.

### Example I

### Hydrophilic film

The coating liquid for forming a hydrophilic film having a composition shown below was coated on a glass plate (Endo Scientific Instrument Co., Ltd.), which is a substrate (support), to obtain a dry coated amount of 2 g/m², and was heat-dried at 120°C for 2 minutes to form the hydrophilic film on the substrate.

| <Coating liquid for forming hydrophilic film> | |
|---|---|
| Sulfonic acid macromonomer (above) | 4 g |
| Ethoxylated trimethylolpropane acrylate (Nippon Kayaku Co., Ltd., SR-9035) | 4g |
| IRGACURE 2959 (Ciba Specialty Chemicals) | 0.5 g |
| Water | 100 g |

### Curing of the hydrophilic film

The substrate having a hydrophilic film was put into a vat, and the top surface was sealed with FORWRAP (manufactured by Riken Technos Corp.) and the air was substituted by nitrogen, and exposure was carried out for 10 minutes using a 400 w high-pressure mercury lamp (manufactured by Rico Kagaku Sangyo Co., Ltd., UVL-400P). The obtained substrate having a hydrophilic cured film was dipped in ion exchange water for 1 minute and was dried at 110°C for 1 minute.

### <Hydrophilicity evaluation>

The contact angle of the obtained hydrophilic cured film was 8.4° when measured with CA-Z manufactured by Kyowa Interface Science Co., Ltd., thus confirming excellent surface hydrophilicity.

### <Durability evaluation>

In order to measure the durability of the hydrophilic film formed on the support, the surface of the obtained hydrophilic film was scrubbed 100 times with a nonwoven fabric (BEMCOT, manufactured by Asahi Kasei Fibers), and the contact angle before and after was measured using CA-Z manufactured by Kyowa Interface Science Co., Ltd. Observation of the material surface after scrubbing showed that the hydrophilic film on the surface was not peeled after scrubbing nor did it have any scratches which can be seen with visual observation. Thus, it was found that the hydrophilic film of Example 1 had sufficient resistance to abrasion. Further, the contact angle before scrubbing was 8.4° and after was 10.6°. Due to sufficient hydrophilicity after scrubbing, the hydrophilic material of the invention was proved to have good abrasion resistance.

Therefore, it was found that the hydrophilic film of the invention has excellent hydrophilicity and durability.

### Example 2

### Preparation of the planographic printing plate precursor

### (1) Preparation of support

### <Aluminum plate>

A molten metal of JIS A 1050 aluminum alloy containing 99.5 % by mass or more of A1, 0.30% by mass of Fe, 0.10% by mass of Si, 0.02% by mass of Ti and 0.013% by mass of Cu with the balance being unavoidable impurities was subjected to a cleaning treatment and casting. In the cleaning treatment, the molten metal was subjected to a degassing treatment for removing unnecessary gases such as hydrogen and the like and further to a ceramic tube filter treatment. The casting was performed by the DC casting method. The solidified ingot having a plate thickness of 500 mm was scalped to 10 mm from the surface and subjected to a homogenization treatment at 550°C for 10 hours so as to prevent the intermetallic compound from becoming coarse. Subsequently, the plate was hot-rolled at 400°C, subjected to intermediate annealing at 500°C for 60 seconds in a continuous annealing furnace, and then cold-rolled to obtain an aluminum rolled plate having a thickness of 0.30 mm. By controlling the roughness of the rolling roller, the center line average surface roughness Ra (according to JIS B0601) after the cold rolling was controlled to 0.2 µm. Thereafter, the plate was applied with a tension leveler to improve the flatness. The obtained aluminum plate was surface-treated as follows.

The aluminum plate was first degreased with an aqueous 10% by mass sodium aluminate solution at 50°C for 30 seconds to remove the rolling oil on the plate surface and then treated for neutralization and desmutting with an aqueous 30% by mass nitric acid solution at 50°C for 30 seconds.

Subsequently, the aluminum plate was subjected to a surface-roughening treatment so as to obtain good adhesion between the image recording layer and the support and at the same time to impart water receptivity to the non-image area. More specifically, while passing the aluminum plate web through an aqueous solution (liquid temperature: 45°C) supplied to an indirect power feed cell and containing 1 % by mass of nitric acid and 0.5 % by mass of aluminum nitrate, the electrolysis was performed by using an alternating waveform having a duty ratio of 1:1 at a current density of 20 A/dm² to give a quantity of electricity of 240 C/dm² when the aluminum plate was serving as the anode, thereby effecting the electrochemical surface-roughening treatment.

Furthermore, the plate was etched with an aqueous 10% by mass sodium hydroxide solution at 35°C for 30 seconds and then treated for neutralization and desmutting with an aqueous 30% by mass sulfuric acid solution at 50°C for 30 seconds.

Thereafter, in order to improve the abrasion resistance, chemical resistance and water receptivity, the aluminum plate was subjected to an anodization treatment. More specifically, while passing the aluminum plate web through an aqueous 20% by mass sulfuric acid solution (liquid temperature: 35°C) supplied to an indirect power feed cell, the electrolysis was performed by using a direct current at a current density of 14 A/dm² to form an anodic oxide film of 2.5 g/m².

Further, in order to ensure hydrophilicity of the non-image area the plate was subjected to a silicate treatment with 1.5% by mass of an aqueous No. 3 sodium silicate solution at 70°C for 15 seconds. The amount of Si deposited was 10 mg/m². The resulting support was washed with water to complete the support. The obtained support had a center line average roughness Ra of 0.25 µm.

### Formation of image recording layer

On the support, 1 g/m² of the polymer below was coated, and the coating liquid for image recording layer (1) having a composition shown below was bar-coated and dried in an oven at 130°C for 1 minute to form an image recording layer having a dry coated amount of 2.0 g/m². Thereafter, the support was subjected to 400 w of high-pressure mercury lamp (manufactured by Rico Kagaku Sangyo Co., Ltd., UVL-400P) for 1 minute which cured the hydrophilic film, thereby forming an image recording layer and obtaining a planographic printing plate precursor.

Coating liquid for image recording layer (1)
• Water 100 g
• Microcapsule (1) described below (as solid content) 5.0 g
• Hydrophilic polymer having a crosslinkable functional group at the terminal fragment [component (A): (P-1)] 3.5 g
• Radical polymerizable compound [component (B): (M-1) structure shown below] 2.5 g
• Surfactant (diethylhexyl sodium sulfosuccinate) 0.2 g
• Polymerization initiator [component(C): structure shown below] 0.15 g

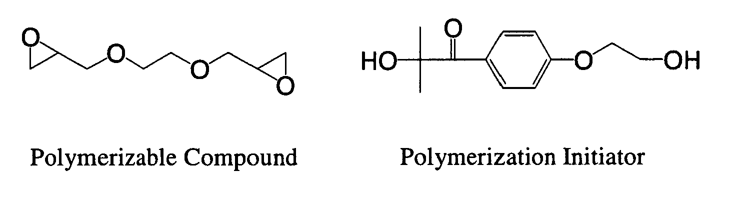

### (Synthesis of microcapsule (1))

As the oil phase component, 10 g of trimethylolpropane and xylene diisocyanate adduct (manufacture by Mitsui Takeda Chemicals, Inc., TAKENATE D-110N), 3.15 g of pentaerythritol triacrylate (manufacture by Nippon Kayaku Co., Ltd., SR444), 0.35 g of infrared absorbent (1) shown below, 1 g of 3-(N,N-diethylamino)-6-methyl-7-anilino-fluorane (manufacture by Yamamoto Chemicals, Inc., ODB), 0.75 g of the polymerization initiator (1) shown below and 0.1 g of Pionin A-41C (manufactured by Takemoto Yushi Co., Ltd.) were dissolved in 17 g of ethyl acetate. As the aqueous phase component, 40 g of 4% by mass of an aqueous carboxylic acid modified polyvinyl alcohol solution (manufactured by Kuraray Co., Ltd., KL-506) was prepared. The oil phase component and the aqueous phase component were mixed and emulsified in a homogenizer at 12,000 rpm for 10 minutes. The resulting emulsified product was added to 25 g of distilled water, stirred at room temperature for 30 minutes and then stirred at 40°C for 3 hours. The obtained microcapsule solution (1) was diluted with distilled water to have a solid content concentration of 20% by mass. The average particle size was 0.4 µm.

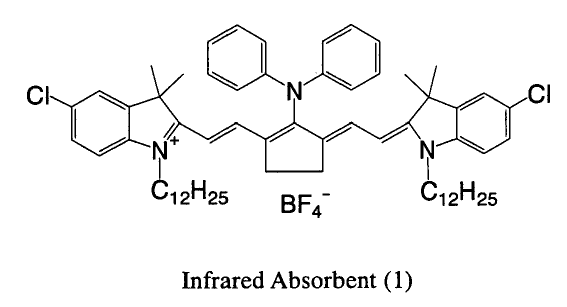

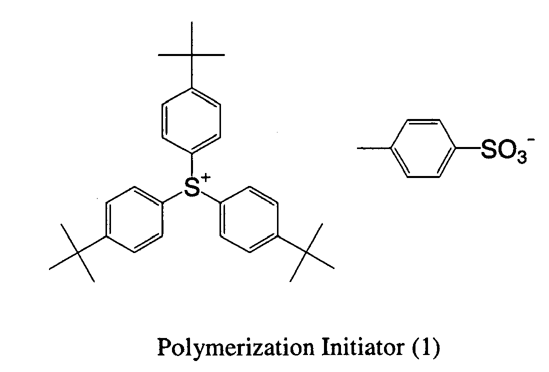

### Examples 3 to 9

Planographic printing plate precursors of Examples 3 to 9 were obtained in the same manner as Example 2, except that the hydrophilic polymer and the radical polymerizable compound (written as polymerizable compound) used in Example 2 were replaced by the compounds shown in Table 1.

### Comparative Example 1

A planographic printing plate precursor of Comparative Example 1 was obtained in the same manner as Example 2, except that the hydrophilic polymer (P-1) and the polymerizable compound (M-1) used in Example 2 were replaced by the comparative polymer (H-1) and the polymerizable compound (M-2).

### Comparative Example 2

A planographic printing plate precursor of Comparative Example 2 was obtained in the same manner as Example 1, except that the hydrophilic polymer (P-1) used in Example 2 was replaced by the comparative polymer (H-2).

Hereinafter, the polymerizable compounds [(M-1) and (M-2)] used in Examples and Comparative Examples, the hydrophilic polymers [(P-1) to (P-5)] used in Examples and the comparative polymers [(H-1) and (H-2)] used in Comparative Examples are described in detail.
M-1: SR-9035 (manufactured by Nippon Kayaku Co., Ltd., Acrylate Monomer)
M-2: SR-444 (manufactured by Nippon Kayaku Co., Ltd., Acrylate Monomer)

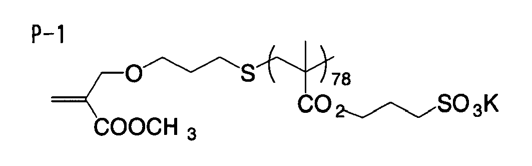

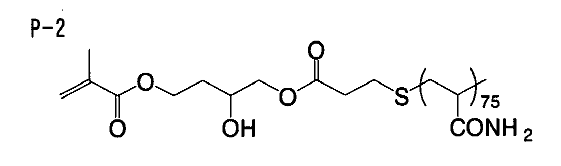

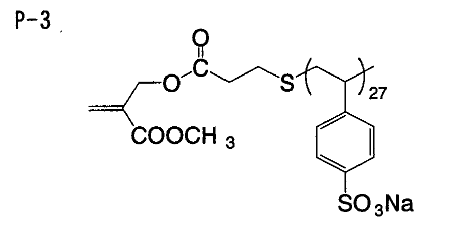

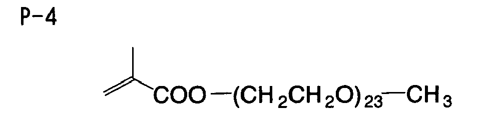

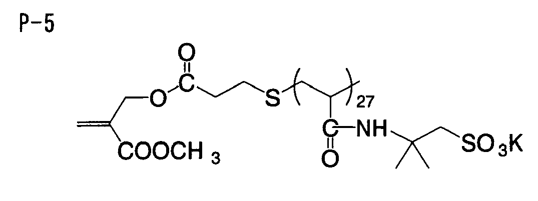

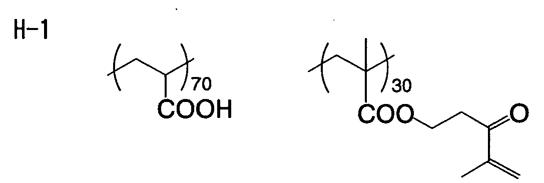

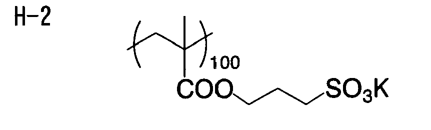

### Exposure and Printing

The obtained planographic printing plate precursors each was exposed by Trendsetter 3244VX (manufactured by Creo Co., Ltd.) having mounted thereon a water cooling 40 W infrared ray semiconductor laser, under such conditions that the output was 9 W, the rotary number of outer surface drum was 210 rpm and the resolution was 2,400 dpi. A fine line chart was included in the exposed image. Thereafter, without passing through development processing, the resulting exposed plate precursor was loaded on a cylinder of a printing press SOR-M manufactured by Heidelberg. Using a fountain solution (EU-3 (an etching solution, manufactured by Fuji Photo Film Co., Ltd.))/water/isopropyl alcohol=1/89/10 (by volume)) and TRNS-G(N) black ink (produced by Dai-Nippon Ink & Chemicals, Inc.), 500 sheets were printed by supplying the fountain solution at a printing speed of 6,000 sheets per hour. Thereafter, the ink was deposited to the plate surface, and by supplying the fountain solution, the number of printing sheets required until the removal of ink from the plate surface was completed on the printing press and the staining of the non-image area on the printed matter did not occur was counted. Then, the printing was continued until the staining occurred.

### Evaluation of planographic printing plate

### (1) Staining

At the 500^{th} sheet, the amount of deposited ink on the printed matter in the non-image area was evaluated by visual observation. An unstained state without any ink deposited is designated by A and a stained state with even a small amount deposited is designated by B.

### (2) Ink removal

Printing was carried out according to the above disclosed method, and the number of sheets necessary for removing ink is counted. The fewer the sheets required for removing ink, the more superior the hydrophilicity of the hydrophilic layer, and thus the more excellent in removing ink.

### (3) Printing durability

At the point of time where staining is generated due to abrasion in the non-image area, the printing is terminated, and the number of printed sheets are counted. By setting the value from Comparative Example 2 as 100, the relative values are shown. The higher the strength of the hydrophilic layer, the greater the value of printing durability and thus the more excellent the printing durability. The evaluation results are shown in Table 1.

**Table 1**

| | (A) Hydrophilic Polymer | (B) Polymerizable Compound | Staining | Ink Removal | Printing Durability |
|---|---|---|---|---|---|
| Ex.2 | P-1 | M-1 | A | 7 | 600 |
| Ex.3 | P-1 | M-2 | A | 10 | 650 |
| Ex. 4 | P-2 | M-1 | A | 11 | 670 |
| Ex.5 | P-3 | M-1 | A | 17 | 500 |
| Ex. 6 | P-1/P-4 (1/1) | M-2 | A | 14 | 550 |
| Ex. 7 | P-5 | M-1 | A | 10 | 600 |
| Comp. Ex. 1 | H-1 | M-2 | B | 500 sheets or more | - |
| Comp. Ex. 2 | H-2 | M-1 | A | 350 sheets | 100 |

As seen from Table 1, it was found that the planographic printing plate precursor of the invention which uses the hydrophilic film of the invention as a recording layer has excellent hydrophilicity in the non-image area, good ink removal, and may form images without staining in the non-image area.

Meanwhile, the planographic printing plate precursor of Comparative Example 1, which uses a general hydrophilic polymer (H-1) having a hydrophilic group or polymerizable group as a polymer chain instead of the specific hydrophilic polymer of the invention, has low surface hydrophilicity of the film compared to the specific hydrophilic polymer, and is considerably insufficient in terms of staining and ink removal compared to the specific hydrophilic polymer, and thus has problems in practical use. Further, in Comparative Example 2, which uses a polymer (H-2) without a radical polymerizable group on the terminal, ink removal is inefficient compared to the Examples. Moreover, it was found that excellent printing durability cannot be obtained due to insufficient adhesion between the hydrophilic film and the support.

According to the polymerizable composition of the invention, a film having high hydrophilicity and high strength can be formed. Further, the cured hydrophilic film formed by using the polymerizable composition has a structure having high crosslinking density and a highly dynamic hydrophilic unit.

Further, by using the above hydrophilic film of the invention as a recording layer, a planographic printing plate precursor which has excellent hydrophilicity and durability in the non-image area can be provided.

## Claims

1. A polymerizable composition comprising:
a hydrophilic polymer (A) having a radical polymerizable group on a terminal;
a radical polymerizable compound (B); and
a polymerization initiator (C).

2. The polymerizable composition according to claim 1, wherein the hydrophilic polymer (A) having a radical polymerizable group on a terminal contains a functional group selected from an alkyl sulfonic acid group or a salt thereof, or an amide group.

3. The polymerizable composition according to claim 1 or 2, wherein the polymerization initiator (C) contains a hydrophilic group.

4. A hydrophilic film formed by curing a film by application of light or heat, wherein the film comprises a polymerizable composition comprising:
a hydrophilic polymer (A) having a radical polymerizable group on a terminal;
a radical polymerizable compound (B); and
a polymerization initiator (C).

5. The hydrophilic film according to claim 4, wherein the hydrophilic polymer (A) having a radical polymerizable group on a terminal contains a functional group selected from an alkyl sulfonic acid group or a salt thereof, or an amide group.

6. The hydrophilic film according to claim 4 or 5, wherein the radical polymerizable compound (B) contains two or more terminal ethylenically unsaturated bonds.

7. The hydrophilic film according to any one of claims 4 to 6 , wherein the polymerization initiator (C) contains a hydrophilic group.

8. A planographic printing plate precursor comprising a support and the hydrophilic film of any one of claims 4 to 7 formed on or above the support.

9. A planographic printing plate precursor comprising a support and the hydrophilic film of any one of claims 4 to 7 formed on or above the support, wherein the hydrophilic film contains at least one kind selected from a compound (D-1) whose hydrophilicity is converted to hydrophobicity upon application of heat, or particles (D-2) whose hydrophilicity is converted to hydrophobicity upon application of heat.

10. The planographic printing plate precursor according to claim 8 or 9, wherein the hydrophilic film further contains an infrared absorbent (E).
